(19) Europäisches Patentamt / European Patent Office / Office européen des brevets

(11) **EP 4 489 085 A1**

(12) **EUROPEAN PATENT APPLICATION**
published in accordance with Art. 153(4) EPC

(43) Date of publication:
**08.01.2025 Bulletin 2025/02**

(21) Application number: **23763721.0**

(22) Date of filing: **03.03.2023**

(51) International Patent Classification (IPC):
$H01L\ 33/50\ ^{(2010.01)}$    $H01L\ 33/06\ ^{(2010.01)}$
$H01L\ 33/08\ ^{(2010.01)}$    $H01L\ 33/14\ ^{(2010.01)}$
$H01L\ 33/32\ ^{(2010.01)}$

(52) Cooperative Patent Classification (CPC):
**H01L 33/08; H01L 33/06;** H01L 25/0753;
H01L 33/24; H01L 33/32; H01L 33/46

(86) International application number:
**PCT/KR2023/002904**

(87) International publication number:
**WO 2023/167523 (07.09.2023 Gazette 2023/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 03.03.2022  US 202263268816 P
03.03.2022  US 202263268826 P
07.10.2022  US 202263414034 P
02.03.2023  US 202318177295

(71) Applicant: **Seoul Viosys Co., Ltd.**
**Ansan-si, Gyeonggi-do 15429 (KR)**

(72) Inventors:
• **YOO, Hong Jae**
**Ansan-Si Gyeonggi-do 15429 (KR)**
• **CHO, Sung Ryoung**
**Ansan-Si Gyeonggi-do 15429 (KR)**

(74) Representative: **Stolmár & Partner**
**Patentanwälte PartG mbB**
**Blumenstraße 17**
**80331 München (DE)**

(54) **MONOLITHIC MULTI-COLOR ELEMENT AND LIGHT-EMITTING MODULE HAVING SAME**

(57)    Disclosed are a monolithic multi-color element and a light-emitting module having same. The monolithic multi-color element according to one embodiment of the present disclosure comprises: a first conductive semiconductor area; a control part arranged on the first conductive semiconductor area; a colored area formed on the control part; and a second conductive semiconductor area formed on the colored area, wherein the colored area comprises a first colored part and a second colored part, and the first colored part emits light with a shorter wavelength than that of the second colored part, while the first colored part or the second colored part emits light with a plurality of peak wavelengths.

FIG. 3

EP 4 489 085 A1

**Description**

[Technical Field]

The present disclosure relates to a monolithic di-chromic device and a light emitting module having the same.

[Background Art]

The implementation of various colors is used in various technical fields in daily life, and for example, various colors are implemented in various technical fields such as lighting, automobiles, light therapy, and displays.

In general, since a light emitting diode emits light having a single narrow full width at half maximum, it emits light of a single color in a visible light region. In order to implement various colors, a plurality of light emitting diodes having different peak wavelengths is used, or wavelength conversion materials such as phosphors are used together with the light emitting diodes.

However, in order to implement various colors using the plurality of light emitting diodes, it is necessary to manufacture light emitting diodes having different peak wavelengths using different materials and arrange them adjacent to one another. Accordingly, it is complicated to manufacture a module for implementing various colors.

Meanwhile, when using a phosphor together with the light emitting diode, it is not easy to arrange a suitable phosphor on the light emitting diode, and furthermore, it is necessary to solve drawbacks such as deterioration of the phosphor or deterioration of a molding member supporting the phosphor. Moreover, efficiency reduction due to the use of the phosphor cannot be avoided. Furthermore, since the phosphor is disposed on the light emitting diode, an increase in size is inevitable.

[DISCLOSURE]

[Technical Problem]

Embodiments according to the present disclosure may provide a monolithic di-chromic device that is capable of providing a module to be stably driven and configured to implement various colors.

Embodiments according to the present disclosure provide a monolithic di-chromic device that is configured to implement various colors without a phosphor.

Embodiments according to the present disclosure provide a monolithic di-chromic device in which a change in color coordinates according to a change in current densities is reduced.

[Technical Solution]

A monolithic di-chromic device according to an embodiment of the present disclosure includes a first conductivity type semiconductor region; a control portion disposed on the first conductivity type semiconductor region; a color region formed on the control portion; and a second conductivity type semiconductor region disposed on the color region, in which the color region includes a first color portion and a second color portion, the first color portion emits light having a shorter wavelength than that of the second color portion, and the first color portion or the second color portion emits light having a plurality of peak wavelengths.

The first color portion may generate blue light, the second color portion may generate green or yellow light, and white light may be implemented by a combination of blue light of the first color portion and green or yellow light of the second color portion.

In an embodiment, each of the first color portion and the second color portion may include a plurality of well layers, and the number of well layers in the first color portion may be greater than the number of well layers in the second color portion.

Each of the first color portion and the second color portion may emit light having a plurality of peak wavelengths.

The monolithic di-chromic device may further include a tunnel barrier layer disposed between the first color portion and the second color portion.

The tunnel barrier layer may include an AlGaN layer or DBR.

The monolithic di-chromic device may further include a bridge region disposed between the first color portion and the second color portion, in which the bridge region may include a first conductivity type high-concentration doping layer and a second conductivity type high-concentration doping layer.

The monolithic di-chromic device may further include a sub-electron blocking layer disposed between the first color portion and the bridge region.

The first conductivity type high-concentration doping layer may be thicker than the second conductivity type high-concentration doping layer.

The color region may be formed of a nitride semiconductor.

In the monolithic di-chromic device, a change amount $\triangle$u'v' of CIE color coordinates generated by a change in current densities from 32 mA/cm$^2$ to 120 mA/cm$^2$ may be less than 0.11.

Furthermore, in the monolithic di-chromic device, the change amount $\triangle$u'v' of CIE color coordinates generated by a change in current densities from 32 mA/cm$^2$ to 120 mA/cm$^2$ may be less than 0.08.

The first color portion may include well layers emitting light of different peak wavelengths, and a difference in composition ratios of In in the well layers may be within a range of 0.001 to 0.08.

An energy band gap difference between the well layers may be less than 0.2eV.

A composition ratio of In in the well layers of the second color portion may be within a range of 0.2 to 0.4.

The second color portion may include well layers emitting light of different peak wavelengths, and a difference in composition ratios of In in the well layers may be within a range of 0.01 to 0.1.

A composition ratio of In in the well layers of the first color portion may be within a range of 0.10 to 0.18.

A light emitting module according to an embodiment of the present disclosure includes a circuit board; and a monolithic di-chromic device disposed on the circuit board, in which the monolithic di-chromic device includes a first conductivity type semiconductor region; a control portion disposed on the first conductivity type semiconductor region; a color region formed on the control portion; and a second conductivity type semiconductor region disposed on the color region, in which the color region includes a first color portion and a second color portion, the first color portion emits light having a shorter wavelength than that of the second color portion, and the first color portion or the second color portion emits light having a plurality of peak wavelengths.

A change amount $\triangle$u'v' of CIE color coordinates generated by a change in current densities from 32 mA/cm$^2$ to 120 mA/cm$^2$ may be less than 0.11.

The first color portion may include well layers emitting light of different peak wavelengths, and a difference in composition ratios of **In** in the well layers may be within a range of 0.001 to 0.08. **In** addition, the second color portion may include well layers emitting light of different peak wavelengths, and a difference in composition ratios of **In** in the well layers may be within a range of 0.01 to 0.1.

[Description of Drawings]

FIG. 1 is a schematic cross-sectional view illustrating a di-chromic device according to an embodiment of the present disclosure.

FIG. 2 is an enlarged cross-sectional view of a portion of FIG. 1.

FIG. 3 is a schematic cross-sectional view illustrating a di-chromic device according to a first embodiment of the present disclosure.

FIG. 4 is a schematic graph illustrating an electroluminescence spectrum of the di-chromic device according to the first embodiment of the present disclosure.

FIG. 5 is a CIE chromaticity diagram illustrating color coordinates of light emitted from the di-chromic device according to the first embodiment of the present disclosure.

FIG. 6 is a schematic cross-sectional view illustrating a di-chromic device according to a second embodiment of the present disclosure.

FIG. 7 is a schematic graph illustrating an electroluminescence spectrum of the di-chromic device according to the second embodiment of the present disclosure.

FIG. 8 is a CIE chromaticity diagram illustrating color coordinates of light emitted from the di-chromic device according to the second embodiment of the present disclosure.

FIG. 9 is a schematic cross-sectional view illustrating a di-chromic device according to a third embodiment of the present disclosure.

FIG. 10 is a schematic graph illustrating an electroluminescence spectrum of the di-chromic device according to the third embodiment of the present disclosure.

FIG. 11 is a CIE chromaticity diagram illustrating color coordinates of light emitted from the di-chromic device according to the third embodiment of the present disclosure.

FIG. 12 is a schematic cross-sectional view illustrating a di-chromic device according to a fourth embodiment of the present disclosure.

FIG. 13 is a schematic graph illustrating an electroluminescence spectrum of the di-chromic device according to the fourth embodiment of the present disclosure.

FIG. 14 is a CIE chromaticity diagram illustrating color coordinates of light emitted from the di-chromic device according to the fourth embodiment of the present disclosure.

FIG. 15 is a schematic cross-sectional view illustrating a di-chromic device according to a fifth embodiment of the present disclosure.

FIG. 16 is a band diagram illustrating the di-chromic device according to the fifth embodiment of the present disclosure.

FIG. 17 is a schematic cross-sectional view illustrating a di-chromic device according to a sixth embodiment of the present disclosure.

FIG. 18A is a band diagram illustrating the di-chromic device according to the sixth embodiment of the present disclosure.

FIG. 18B is a band diagram showing an enlarged color region of FIG. 18A.

FIG. 19A is a schematic cross-sectional view illustrating a di-chromic device according to a seventh embodiment of the present disclosure.

FIG. 19B is a band diagram showing an enlarged color region of FIG. 19A.

FIG. 20 is a schematic cross-sectional view illustrating a light emitting device according to an embodiment of the present disclosure.

FIG. 21 is a schematic cross-sectional view illustrating a light emitting module according to an embodiment of the present disclosure.

FIG. 22 is a schematic cross-sectional view illustrating a light emitting device according to another embodiment of the present disclosure.

FIG. 23 is a schematic cross-sectional view illustrating a light emitting device according to another embodiment of the present disclosure.

FIG. 24 is a cross-sectional view illustrating a display apparatus to which a di-chromic device according to an embodiment of the present disclosure is applied.

FIG. 25 is a cross-sectional view illustrating a display apparatus to which a di-chromic device according to another embodiment of the present disclosure is applied.

FIG. 26 is a cross-sectional view illustrating a lighting apparatus to which a di-chromic device according to another embodiment of the present disclosure is applied.

FIGS. 27A, 27B, and 27C are a schematic cross-sectional view, a plan view, and a circuit diagram illustrating a display apparatus to which a di-chromic device according to another embodiment of the present disclosure is applied, respectively.

FIGs. 28A and 28B is a cross-sectional view and a plan view illustrating a light emitting apparatus to which a di-chromic device according to another embodiment of the present disclosure is applied, respectively.

[Detailed Description of the Illustrated Embodiments]

Hereinafter, exemplary embodiments of the present disclosure will be described in detail with reference to the accompanying drawings. The following exemplary embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. In addition, when an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

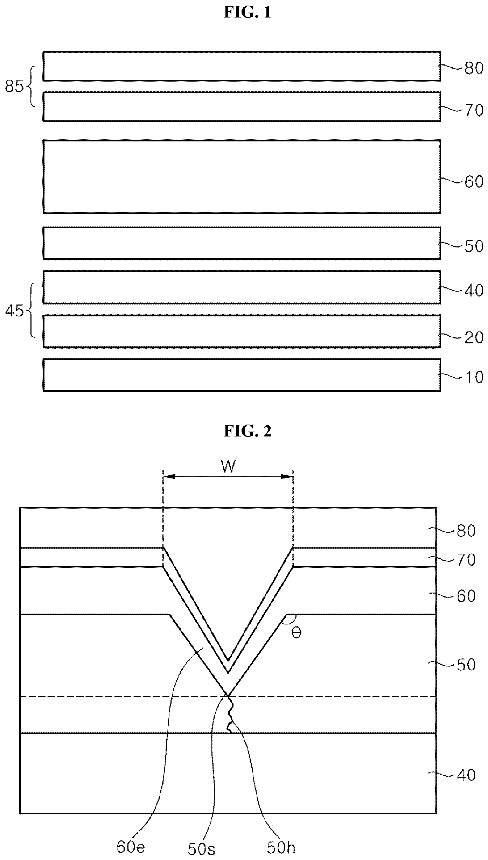

FIG. 1 is a schematic cross-sectional view illustrating a di-chromic device according to an embodiment of the present disclosure.

Referring to FIG. 1, the di-chromic device according to this embodiment may include a base 10, a buffer layer 20, a first conductivity type semiconductor layer 40, a control portion 50, a color region 60, a resistor 70, and a second conductivity type semiconductor layer 80.

The base 10 may be a printed circuit board, a sapphire substrate, a silicone substrate, a GaN substrate, polyimide, an epoxy molding compound (EMC), or the like. The base 10 may be disposed on a path through which light emitted from the color region 60 passes or transmits. Light may pass through the base 10 and be emitted to the outside of the di-chromic device.

The base 10 may have irregularities on its surface, and light may be scattered using the irregularities. In a case that the color region 60 emits light having a plurality of peak wavelengths, light having different peak wavelengths may be mixed in the base 10. That is, the base 10 may serve as a mixing zone of light.

The buffer layer 20 is a low-temperature buffer layer for growing a gallium nitride-based semiconductor layer on a heterogeneous substrate, for example, a nucleation layer, and may be formed of, for example, at least one of AlN, undoped GaN, and AlGaN. A high-temperature buffer layer, for example, an undoped GaN layer, may be further formed on the buffer layer 20.

The first conductivity type semiconductor layer 40 may serve as a contact layer for supplying electricity to the dichromic device. The first conductivity type semiconductor layer 40 may include a III-V material such as AlxInyGa(1-x-y)N (x, y>=0), GaAs, or GaInP, and may be doped with a dopant such as Si. The buffer layer 20 and the first conductivity type semiconductor layer 40 may form a first conductivity type semiconductor region 45.

The color region 60 may be formed on the first conductivity type semiconductor layer 40. The color region 60 may include a III-V material such as AlxInyGa(1-xy)N (x, y>=0) or GaAs and GaInP. The color region 60 may have a structure in which a plurality of color portions emitting light of different colors is vertically stacked with one another. The plurality of color portions may include a first color portion and a second color portion. Each of the color portions may have different types of color materials that determine a peak wavelength, CIE, or CRI of emitted light, or may have different amounts of color materials. For example, the first color portion and the second color portion may have different peak wavelengths, and the color material of the first color portion may emit light of a shorter wavelength than that of the color material of the second color portion. For example, the first color portion may emit blue light, and the second color portion may emit green or yellow light.

In an embodiment, the first color portion emitting light of a relatively shorter peak wavelength may be disposed closer to the first conductivity type semiconductor layer 40 than the second color portion, and the second color portion emitting light having a relatively longer peak wavelength may be disposed closer to the second conductivity type semiconductor layer 80 than the first color portion. However, the inventive concepts are not limited thereto, and positions of the first color portion and the second color portion may be changed according to a device structure.

The resistor 70 may be formed on the color region 60. The resistor 70 may serve as a resistor in a flow of current, and may function as a barrier to prevent electrons injected from the first conductivity type semiconductor layer 40 from flowing into the second conductivity type semiconductor layer 80. The resistor 70 may include a III-V material such as AlxInyGa(1-x-y)N (x, y >=0) or GaAs or GaInP, and may have an energy band gap wider than those of the first and second conductivity type semiconductor layers 40 and 80. For example, the energy band gap of at least one layer of the resistor 70 may be wider than that of at least one layer of the first and second conductivity type semiconductor layers 40 and 80 by 0.9 eV or more. The resistor 70 may be formed of a single layer or a plurality of layers. When formed of the plurality of layers, a plurality of layers having different Al contents or band gap energies may be included, and in this case, a layer having a relatively high Al content or a layer having a relatively wide band gap energy may be disposed closer to the color region 60. A difference in Al contents between a layer with a relatively high Al content and a layer with a relatively low Al content may be within 10%, or a difference in band gap energies may be within 0.6eV. **In** another embodiment, a profile of the Al content of the resistor 70 may be substantially similar to that of an In content of the resistor 70. That is, the In content may be relatively high where the Al content is relatively high, and the In content may be relatively low where the Al content is relatively low. However, the inventive concepts are not necessarily limited thereto, and the profile of the Al content and that of the In content may be different. For example, when an Al content increases in the Al profile, an In content may be decrease, or when an In content increasesin the In profile, an Al content may decrease in the Al profile.

The control portion 50 may be formed between the first conductivity type semiconductor layer 40 and the color region 60. As shown in FIG. 2, the control portion 50 may include a holding unit 50h generating a spot 50s. The control portion 50 may include a material such as InGaN, GaN, InGaAs or GaAs, and a portion of the color region 60 may extend toward the spot 50s by the spot 50s formed on the holding portion 50h to form an extension portion 60e. The holding portion 50h may be formed by forming a holding layer using a TMGa material. The holding portion 50h may have a height of about 1000Å to about 2500Å. A plurality of holding portions 50h may be formed in the control portion 50, and the plurality of holding portions 50h may be laterally spaced apart.

The control portion 50 may include an expansion portion at a boundary portion with the color region 60. The expansion portion assists to form the extension portion 60e of the color region 60 extending in a direction of the spot 50s of the holding portion 50h larger. The extension portion 60e may be formed in a V shape, and may include a color portion. The expansion portion may be formed of a single layer or multiple layers, and may include, for example, a superlattice structure. A material for the expansion portion may include a III-V material such as AlxInyGa(1-x-y)N (x, y >= 0), GaAs, or GaInP, and may include a dopant such as Si. In a case of including the dopant, a doping concentration may be in a concentration range of $1E17/cm^3$ to $5E18/cm^3$. The expansion portion may be formed within a thickness range of 1000Å to 2500Å. The expansion portion may have a band gap corresponding to that of light having a wavelength of 405nm or less. The superlattice structure for the expansion portion may have, for example, a structure in which InGaN/GaN or InGaN/InGaN are repeatedly stacked. However, the inventive concepts are not limited thereto, and the superlattice structure may be at least two or more layers having different doping concentrations, or may be at least two or more layers having different band gap energies from one another.

The control portion 50 may further include an intermediate layer between the holding portion 50h and the expansion portion. The intermediate layer may be formed of a plurality of layers, may include a III-V material such as AlxInyGa(1-x-y)N (x, y >= 0) or GaAs or GaInP, and each of the plurality of layers may have a thickness of about 10Å to 150Å.

The second conductivity type semiconductor layer 80 may be formed on the resistor 70. The second conductivity type semiconductor layer 80 may have a polarity opposite to that of the first conductivity type semiconductor layer 40, and may include, for example, materials such as Mg and B. The resistor 70 and the second conductivity type semiconductor layer 80 may form a second conductivity type semiconductor region 85. A material such as Mg or B of the second conductivity type semiconductor layer 80 may have an inclined profile, and may have a left-right asymmetrical profile with respect to a peak point having a highest content of the material. Preferably, an inclination of the profile in a direction closer to the color region 60 with respect to the peak point may be relatively gentler than that of the profile disposed opposite to the peak point.

Although not shown in the drawing, a bridge region having a same polarity as that of the first conductivity type semiconductor layer 40 may be further formed on the second conductivity type semiconductor layer 80. A color region emitting light of a different color may be further formed on the color device of the embodiment via the bridge region.

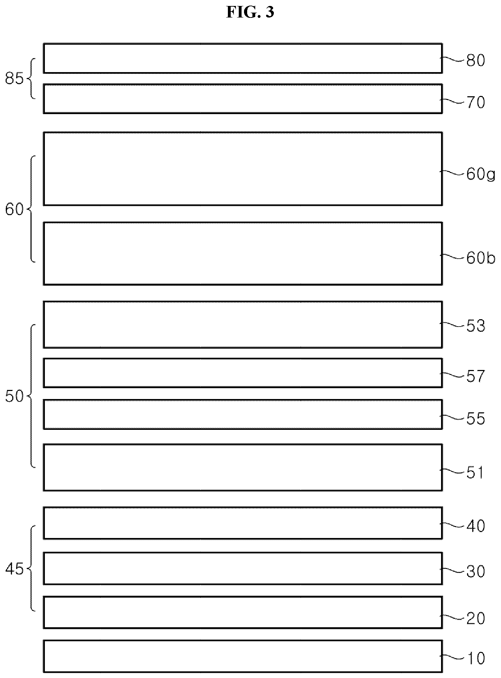

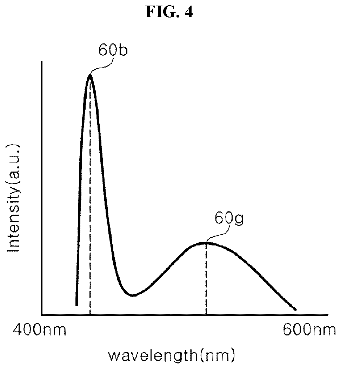

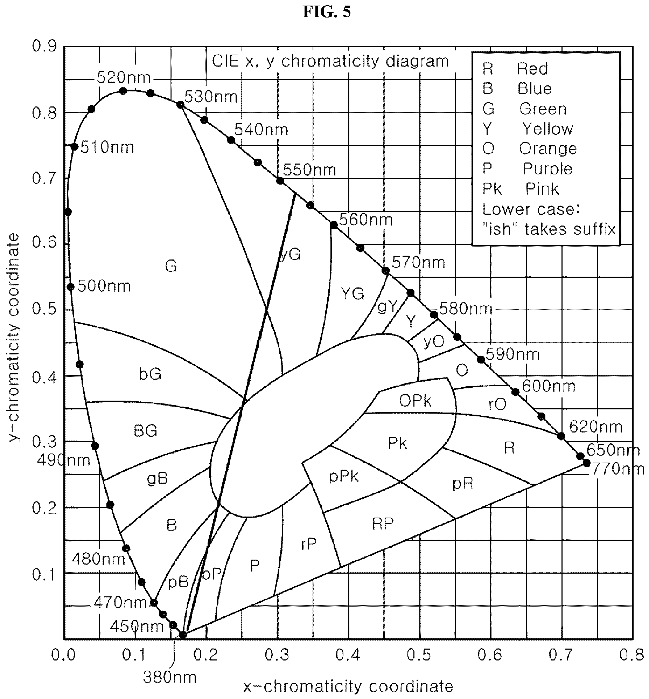

Hereinafter, specific examples of the di-chromic device will be described in more detail. FIG. 3 is a schematic cross-sectional view illustrating a di-chromic device according to a first embodiment of the present disclosure, FIG. 4 is a schematic graph illustrating an electroluminescence spectrum of the di-chromic device according to the first embodiment of the present disclosure, and FIG. 5 is a CIE chromaticity diagram illustrating color coordinates of light emitted from the di-chromic device according to the first embodiment of the present disclosure.

Referring to FIG. 3, the di-chromic device according to this embodiment may include a base 10, a first conductivity type semiconductor region 45, a control portion 50, a color region 60, and a second conductivity type semiconductor region 85 as described with reference to FIG. 1.

Since the base 10 is same as that described with reference to FIG. 1, a detailed description thereof will be omitted to avoid redundancy. The first conductivity type semiconductor region 45 may include a buffer layer 20, an undoped GaN layer 30, and a first conductivity type semiconductor layer 40. The first conductivity type semiconductor region 45 of this embodiment is same as the first conductivity type semiconductor region 45 described with reference to FIG. 1, except that the undoped GaN layer 30 is clearly shown in the drawing, and a detailed description thereof is omitted.

The control portion 50 may be formed of a plurality of layers. As shown in FIG. 3, the control portion 50 may include a first VGL (V-pit generation layer, 51), a first intermediate layer 55, a second intermediate layer 57, and a second VGL 53. Each of the layers of the control portion 50 may be formed of $Al_xIn_yGa_{(1-x-y)}N$ (x, y>=0) or GaAs or GaInP, and the first and second intermediate layers may include layers having different band gap energies from each other, respectively.

As shown in FIG. 3, among the layers of the control portion 50, the first VGL 51 may be disposed closest to the first conductivity type semiconductor layer 40, and the second VGL 53 may be closest to a second conductivity type semiconductor layer 80. The first intermediate layer 55 and the second intermediate layer 57 may be disposed between the first VGL 51 and the second VGL 53. Additional layers may be further included between these layers, but the inventive concepts are not necessarily limited thereto.

The first VGL 51 may be grown at a temperature lower than a growth temperature of the first conductivity type semiconductor layer 40, for example, 900°C or lower, and may include a GaN layer. The first VGL 51 may be formed using a TMGa source to increase a growth rate, which may adjust a size and a density of a holding portion, for example, a V-pit. The first VGL 51 may be formed to have a thickness within a range of about 1000Å to about 2500Å. The first VGL 51 may have a thickness larger than that of the second VGL 53, and a thickness difference may be preferable within 30%. A sum of the thicknesses of the first VGL 51 and the second VGL 53 may be greater than a sum of the thicknesses of the color region 60. Alternatively, the sum of the thicknesses of the first VGL 51 and the second VGL 53 may be greater than a sum of thicknesses of the resistor 70 and the second conductivity type semiconductor layer 80. Accordingly, even when an extension portion 60e of a spot 50s is formed under the color region 60, a lower portion of the color region 60 may be supported. Alternatively, the sum of the thicknesses of the first VGL 51 and the second VGL 53 may be greater than a thickness from an interface between the second VGL 51 and an adjacent layer in a direction of the light emitting region 60 to an interface where the second conductivity type semiconductor layer 80 is electrically connected to a conductive electrode. In this case, a difference in thicknesses thereof may be 1.5 times or more. A doping concentration of the first conductivity type semiconductor layer 40 may be 7 times greater than that of at least one of the first VGL 51 and the second VGL 53. Therefore, by reducing defects in the first VGL 51 or the second VGL 53, light generated from a light emitting device may be prevented from deviating from a target CIE color coordinate due to the defects.

The first intermediate layer 55 or the second intermediate layer 57 is a layer added to substantially control strain, which may be formed of AlN, $Al_xGa_{(1-x)}N$, or GaN. Each of the first and second intermediate layers 55 and 57 may have a thickness of about 10Å to about 150Å. The first intermediate layer 55 or the second intermediate layer 57 may include an n-type dopant. A doping concentration of the first intermediate layer 55 or the second intermediate layer 57 may be lower than that of the first conductivity type semiconductor layer 40, and higher than that of the second VGL 53.

The second VGL 53 may be a single layer or a multiple layers, and may have a superlattice structure, but the inventive concepts are not necessarily limited thereto. The second VGL 53 may be formed of InGaN/GaN or GaN or InGaN or AlInGaN or a combination thereof, and for example, it may be InGaN/GaN containing In to have an energy band gap corresponding to an energy of a wavelength of 405nm or less. In this case, the second VGL 53 may grow relatively slowly along a V-pit structure formed in the first VGL 51 by using a TEGa source as a Ga source. The second VGL 53 may be grown at a temperature lower than the growth temperature of the first conductivity type semiconductor layer 40, for example, 900°C or less. The second VGL 53 may be formed to have a thickness of about 1000Å to about 2500Å, and may be doped with impurities. For example, a doping concentration of silicon doped into the second VGL 53 may be 1E17/cm$^3$ to 5E18/cm$^3$.

When analyzed with SIMS (secondary ion mass spectrometry), a material having a largest standard atomic weight (relative atomic mass or standard atomic weight) or a material having a largest atomic number among group 3 elements included in the di-chromic device may be detected in the second VGL 53. A detection amount of the material having the largest standard atomic weight or atomic number may gradually decrease toward a direction of the first conductivity type semiconductor layer 40. When analyzed with SIMS, a thickness of a gradually decreasing region of the material having the largest standard atomic weight or atomic number may be detected as a larger thickness than a thickness of the color region 60. Accordingly, since the region in which the material having the largest standard atomic weight or atomic number is detected is formed wide in a region between the first conductivity type semiconductor layer 40 and the second conductivity type semiconductor layer 80, it makes it possible to effectively generate white light through a combination of peak wavelengths generated in the color region 60.

The color region 60 may include a plurality of color portions 60b and 60g. As shown in FIG. 4, for example, a first color portion 60b may emit light of 400nm to 500nm or blue light, and a second color portion 60g may emit light of 500nm to 600nm or green or yellow light. The first and second color portions 60b and 60g may have a single or multi-quantum well structure, and may include InGaN, InAlGaN, GaInP, or GaInAlP well layers.

As shown in FIG. 5, color coordinates are determined by mixed color light emitted from the first color portion 60b and the second color portion 60g. When peak wavelengths of light emitted from the first color portion 60b and the second color portion 60g are constant, color coordinates of light emitted from the di-chromic device will move along a linear line of the color coordinates shown in FIG. 5. However, when a current density increases, band bending occurs, and accordingly, the peak wavelengths of light emitted from the first color portion 60b and the second color portion 60g shift to a shorter wavelength side. Therefore, as the current density increases, the peak wavelengths and intensities of light emitted from the first color portion 60b and the second color portion 60g change together, and thus, a large change in color coordinates may occur.

To prevent mixed-color light emitted from the di-chromic device from deviating from a white light region, an In content greater than an In content calculated for emitting light of a target wavelength may be incorporated to the first color portion 60b and the second color portion 60g. Accordingly, even when the peak wavelength of actually emitted light shifts to the shorter wavelength side due to the band bending, mixed color light emitted from the di-chromic device may be within a color coordinate range of white light.

For example, the first color portion 60b may have an In content set to emit light having a peak wavelength within a range of 440nm to 495nm, and the second color portion 60g may have an In content set to emit light having a peak wavelength within a range of 550nm to 595nm. The peak wavelength set by a composition of the first color portion 60b corresponds to a longer wavelength band among blue bands, and the peak wavelength set by a composition of the second color portion 60g corresponds to a longer wavelength band among yellow bands. That is, the compositions of the semiconductor layers of the first and second color portions 60b and 60g may be formed to emit light in the longer wavelength band. Accordingly, when an electrode is formed on the di-chromic device to be implemented as a chip and current is injected, band bending occurs due to strain inside the color portions, and thus, light shifted to a shorter wavelength is emitted. By adjusting the compositions of the first and second color portions 60b and 60g to emit light of the relatively longer wavelength by increasing the In content in advance, light emitted from the di-chromic device may be prevented from deviating from the CIE (x, y) coordinates of white light range.

According to the first embodiment of the present disclosure, in a case that the peak wavelength of light emitted from each of the first and second color portions 60b and 60g is single, an amount of a material (for example, an amount of indium or aluminum) that determines the peak wavelengths of light emitted from the first and second color portions 60b and 60g is formed to be smaller or larger than a target peak in consideration of an applied current value. That is, by intentionally differentiating a peak wavelength calculated by the band gap energy resulting from the composition of the semiconductor layer from the target peak wavelength generated when the device is driven by applying an actual current, it is possible to implement the color coordinates CIE (x, y) of white light that is stable even with an increase in current.

For example, the well layers of the color portions 60b and 60g may be formed of AlxInyGa(1-x-y)N ($0 \leq x$, $y \leq 1$), and the content of Al or In, which is a wavelength control material, can be measured using an atomic probe. An estimate of an energy band gap (Eg) of the well layer may be derived using the measured content of the wavelength control material. For example, in a case that the well layer is InxGa(1-x)N (0<x<1), the energy band gap Eg(x) may be calculated by Equation 1.

$$\text{Equation 1}): \text{Eg}(x) = (1-x)\text{Eg(GaN)} + x\text{Eg(InN)} - bx(1-x).$$

Herein, b=1.00eV, Eg(GaN)= 3.437eV, Eg(InN)= 1.950eV.

An expected peak wavelength ($W_{Ex}$) may be obtained by dividing 1240 nm by the calculated energy band gap. The expected peak wavelength ($W_{Ex}$) derived in this way may be different from an actual peak wavelength ($W_{EL}$) generated by applying a current implemented in an actual chip. According to this embodiment, a composition of the well layer may be determined such that the calculated expected peak wavelength ($W_{EX}$) is a longer wavelength compared to the actual peak wavelength ($W_{EL}$) generated by applying the current.

Regarding the composition of at least one well layer AlxInyGa(1-x-y)N detected using the atomic probe, when the energy band gap derived through the Equation 1 is referred to as a first energy band gap, and the energy band gap derived by dividing 1240nm by at least one peak wavelength emitted from the light emitting device operated under a current density of 120mA/cm$^2$ is referred to as a second energy band gap, a difference between the first energy band gap and the second energy band gap may be 0.2eV or less. By setting the difference to 0.2eV or less, a color coordinate change may be reduced even when the current supplied to the light emitting device changes.

Meanwhile, a V-shaped extension (60e in FIG. 3) is formed by the control portion 50, and thus, strain relief of the color region 60 occurs. Accordingly, a larger amount of In may be introduced into the color region 60, and thus, the composition of the semiconductor layer having the expected peak wavelength of the longer wavelength may be easily formed.

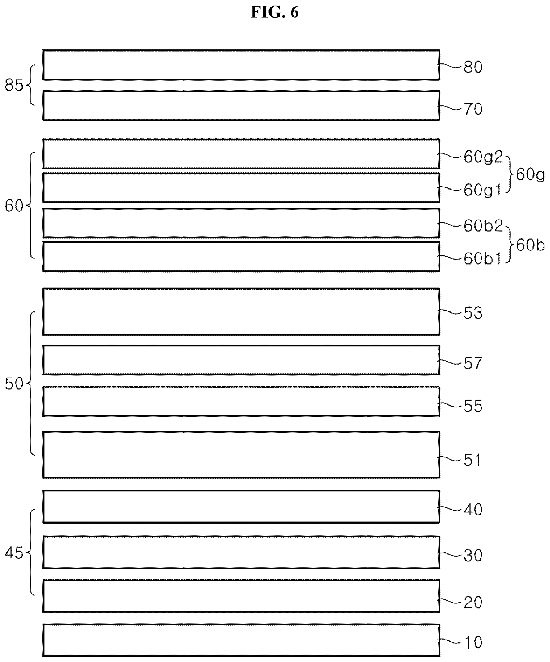

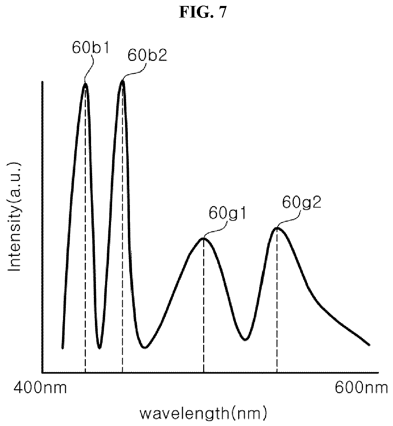

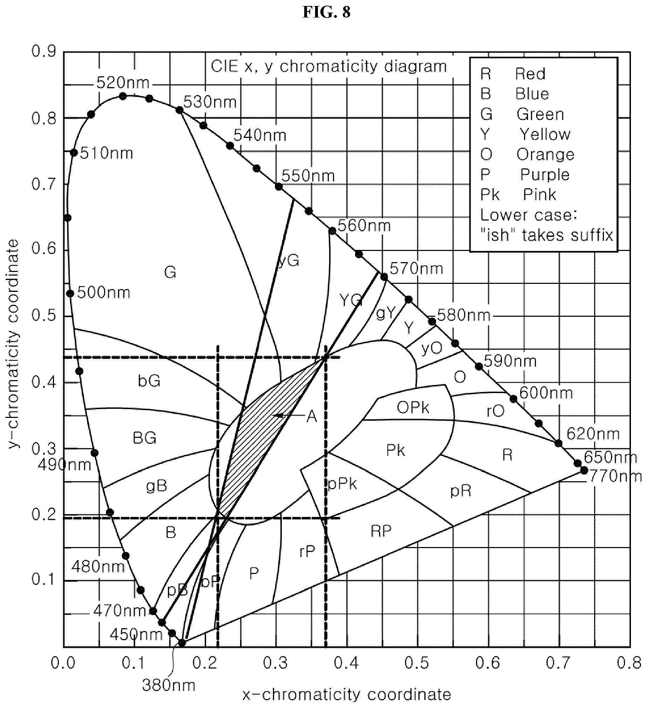

FIG. 6 is a schematic cross-sectional view illustrating a di-chromic device according to a second embodiment of the present disclosure, FIG. 7 is a schematic graph illustrating an electroluminescence spectrum of the di-chromic device according to the second embodiment of the present disclosure, and FIG. 8 is a CIE chromaticity diagram illustrating color coordinates of light emitted from the di-chromic device according to the second embodiment of the present disclosure.

Referring to FIG. 6, the di-chromic device according to this embodiment is generally similar to the di-chromic device described with reference to FIG. 3, except that the color portions in the color region 60 include sub-color portions. That is, the first color portion 60b may include first and second sub-color portions 60b1 and 60b2, and the second color portion 60g may include first and second sub-color portions 60g1 and 60g2. Each of the first and second sub-color portions 60b1 and 60b2 may have a single or multi-quantum well structure emitting light in a blue region, and each of the first and second sub-color portions 60g1 and 60g2 may have a single or multi-quantum well structure emitting light in yellow region. In an embodiment, a total number of well layers in the first sub-color portion 60b1 and the second sub-color portion 60b2 may be 9, and a total number of well layers in the second sub-color portion 60g1 and the second sub-color portion 60g2 may be 6. In an embodiment, the first sub-color portion 60b1 may include five well layers, and the second sub-color portion 60b2 may include well layers that may include four well layers. In addition, each of the first and second sub-color portions 60g1 and 60g2 may include three well layers. Preferably, the total number of well layers in the first sub-color portion 60b1 and the second sub-color portion 60b2 may be greater than the total number of well layers in the second sub-color portion 60g1 and the second sub-color portion 60g2. Accordingly, light emitted from the semiconductor layers of the light emitting device may be arranged in CIE (0.20<x<0.5, 0.19<y<0.45) color coordinates by adjusting a luminous intensity ratio thereof. However, the inventive concepts are not limited thereto, and the number of well layers in each of the sub-color portions may be changed.

The second sub-color portion 60b2 may emit light having a longer wavelength than that of the first sub-color portion 60b1. Specifically, the first sub-color portion 60b1 may emit light having a peak wavelength within a range of 410nm to 455nm, and the second sub-color portion 60b2 may emit light having a peak wavelength within a range of 455nm to 495nm. In an embodiment, a gap between the peak wavelength of light emitted from the first sub-color portion 60b1 and the peak wavelength of light emitted from the second sub-color portion 60b2 may be 10nm to 45nm. Meanwhile, a composition ratio (y) of In contained in the well layers of the first sub-color portion 60b1 may be more than 0.1 and less than 0.15, and a composition ratio (y) of In contained in the well layers of the second sub-color portion 60b2 may be more than 0.15 and less than 0.18. A difference between the composition ratio of In contained in the well layers of the first sub-color portion 60b1 and the composition ratio of In contained in the well layers of the second sub-color portion 60b2 may be in a range of 0.001 to 0.08. By limiting the difference in the composition ratio of In within this range, it is possible to maintain favorable crystalline quality of the well layers.

The second sub-color portion 60g2 may emit light having a longer wavelength than that of the first sub-color portion 60g1. For example, the first sub-color portion 60g1 may emit light having a peak wavelength within a range of 505nm to 550nm, and the second sub-color portion 60g2 may emit light having a peak wavelength within a range of 550nm to 595nm. A gap between the peak wavelength of light emitted from the first sub-color portion 60g1 and the peak wavelength of light emitted from the second sub-color portion 60g2 may be 5nm to 45nm. A gap between the peak wavelength of light emitted from the first color portion 60b and the peak wavelength of light emitted from the second color portion 60g may be 10nm to 185nm. For example, a gap between the peak wavelength of light emitted from the second sub-color portion 60b2 and the peak wavelength of light emitted from the first sub-color portion 60g1 may be 10nm to 55nm. Meanwhile, a composition ratio (y) of In contained in the well layers of the first sub-color portion 60g1 may be more than 0.2 and less than 0.30, and a composition ratio (y) of In contained in the well layers of the second sub-color portion 60g2 may be more than 0.30 and less than 0.40. A difference between the composition ratio of In contained in the well layers of the first sub-color portion 60g1 and the composition ratio of In contained in the well layers of the second sub-color portion 60g2 may be less than 0.001 to 0.1. By limiting the difference in the composition ratio of In within this range, it is possible to maintain favorable crystalline quality of the well layers.

To implement white light, a combination of the peak wavelengths of light emitted from the first and second color portions 60b and 60g and an intensity of light emitted from them are important. When a current supplied to the di-chromic device is low current, that is, under a low current density, white light may be implemented by a combination of the first color portion 60b1 emitting light having the peak wavelength of 410nm to 455nm and the first color portion 60g1 emitting light having the peak wavelength of 505nm to 550nm. Meanwhile, in a case that the current changes from a low current to a high current, a blue shift phenomenon in which a peak wavelength of light emitted from the semiconductor layer shifts to a shorter wavelength side may occur due to band bending inside the semiconductor layer. However, in this embodiment, white light may be implemented by the combination of the second color portion 60b2 emitting light of the peak wavelength between 455nm and 495nm and the second color portion 60g2 emitting light of the peak wavelength between 550nm and 595nm. That is, even when light emitted from the first color portion 60b1 and the first color portion 60g1 is shifted to a shorter wavelength by high current driving and white light is not implemented by them, the second color portion 60b2 and the second color portion 60g2 may replace and supplement the first color portions 60b1 and 60g1. Accordingly, even when a driving current value changes, a change width of the CIE color coordinate may be reduced, thereby stably implementing white light. That is, since a change amount of the CIE color coordinates according to the current change decreases, a probability that white light emitted from the di-chromic device is positioned in a range of CIE (x, y) $0.20 \leq x \leq 0.5$, $0.19 \leq y \leq 0.450$ increases. Moreover, even when the current value changes from the low current to the high current as a range of a white region covered by light of peak wavelengths emitted from the color region 60 increases, a probability that the color coordinates of light generated from the di-chromic device are positioned within a white coordinate range of the CIE color coordinates increases. Alternatively, contrary to this, even when the current value changes from the high current to the low current, a mutual complementary action is possible as described above, and thus, stable white color coordinates may be implemented.

Referring to FIG. 7, since light having a plurality of peak wavelengths is emitted by the first and second sub-color portions 60b1 and 60b2 in the first color portion 60b, and light having a plurality of peak wavelengths is emitted by the first and second sub-color portions 60g1 and 60g2 in the second color portion 60g, light of the plurality of peak wavelengths complements each other even when the current value changes. When the color portion emits light of a single peak wavelength, a full width at half maximum is relatively small, and thus, a range of wavelengths that can be covered is narrow. On the contrary, by forming the color portions to emit light of the plurality of peak wavelengths, and by adjusting the current, a CIE (x, y) area A capable of emitting white light may be increased as shown in FIG. 8. In addition, when a current density increases from 32mA/cm$^2$ to 120mA/cm$^2$, it may change within a range of CIE(x, y) $0.22<x<0.37$, or may change within a range of CIE(x, y) $0.19<y<0.44$. Preferably, when the current density increases from 50mA/cm$^2$ to 100mA/cm$^2$, it may change within a range of CIE(x, y) $0.22<x<0.37$, or may change within a range of CIE(x, y) $0.19<y<0.44$.

In this embodiment, it has been described that the first color portion 60b and the second color portion 60g include the first and second sub-color portions 60b1 and 60b2; 60g1 and 60g2, respectively, and emit light of two peak wavelengths, but the inventive concepts are not limited thereto, and they may include a larger number of sub-color portions emitting light of different peak wavelengths.

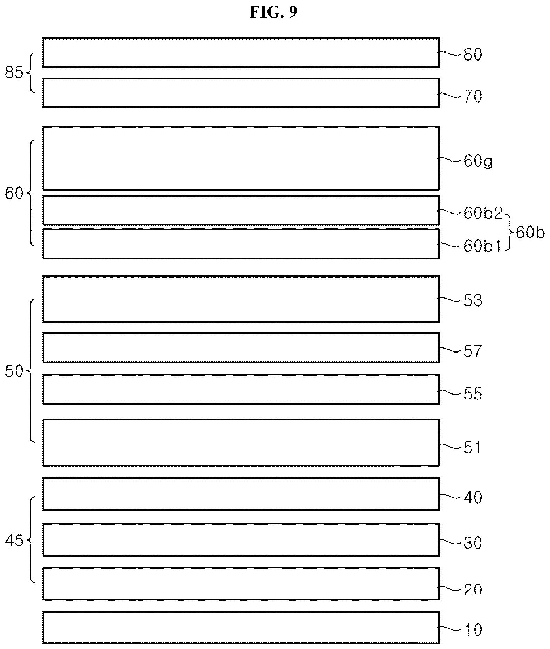

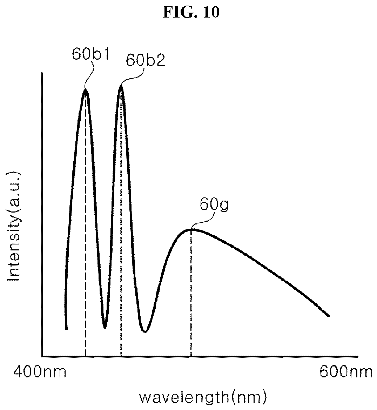

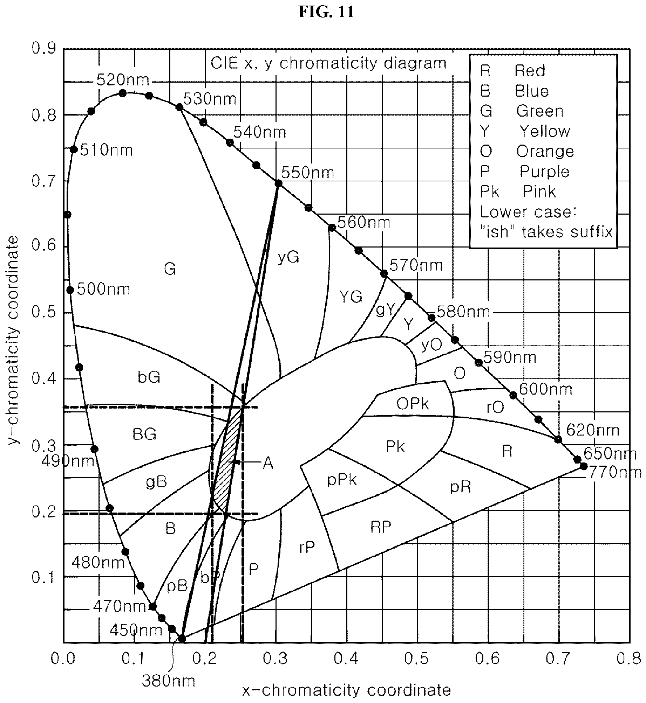

FIG. 9 is a schematic cross-sectional view illustrating a di-chromic device according to a third embodiment of the present disclosure, FIG. 10 is a schematic graph illustrating an electroluminescence spectrum of the di-chromic device according to the third embodiment of the present disclosure, and FIG. 11 is a CIE chromaticity diagram illustrating color coordinates of light emitted from the di-chromic device according to the third embodiment of the present disclosure.

Referring to FIG. 9, the di-chromic device according to this embodiment is substantially similar to the di-chromic device described with reference to FIG. 6, but the second color portion 60g emitting green or yellow light emits light with a single peak wavelength while the first color portion 60b emitting blue light includes the first and second sub-color portions 60b1 and 60b2. That is, in this embodiment, the second color portion 60g does not include the first and second sub-color portions 60g1 and 60g2 emitting light having different peak wavelengths.

Since the first sub-color portion 60b1 and the second sub-color portion 60b2 have been described with reference to FIG. 6, detailed descriptions thereof are omitted to avoid redundancy. Meanwhile, the second color portion 60g may emit light having a peak wavelength of 505nm to 595nm. A composition ratio (y) of In in well layers of the second color portion 60g may be 0.2 to 0.4.

When a low current is supplied to the di-chromic device, it is possible to implement white light by a combination of the first sub-color portion 60b1 emitting light having a peak wavelength of 410nm to 455nm and the color portion 60g emitting light having a peak wavelength of 505nm to 595nm. When a high current is applied to the di-chromic device, a blue shift phenomenon in which a peak wavelength of light emitted from each color portion is shortened may occur due to band bending inside a semiconductor layer. In this case, since light emitted from the second sub-color portion 60b2 emitting light having a peak wavelength of 455nm to 495nm is shifted to a shorter wavelength side by the high current, a combination of the first sub-color portion 60b1 and the color portion 60g under a low current may be supplemented with a combination of the second sub-color portion 60b2 and the color portion 60g under a high current, thereby preventing light emitted from the di-chromic device from deviating from white light CIE color coordinates. Accordingly, even when a current value applied to the di-chromic device changes, a change width of the CIE color coordinate may be reduced, thereby stably implementing white light. That is, since a change amount of the CIE color coordinates according to the current change decreases, a probability that white light emitted from the di-chromic device is positioned in a range of CIE (x, y) 0.20≤x≤0.5, 0.19≤y≤0.450 increases. Moreover, even when the current value changes from the low current to the high current as a range of a white region covered by light of peak wavelengths emitted from the color region 60 increases, a probability that the color coordinates of light generated from the di-chromic device are positioned within a white coordinate range of the CIE color coordinates increases. Alternatively, contrary to this, even when the current value changes from the high current to the low current, a mutual complementary action is possible as described above, and thus, stable white color coordinates may be implemented.

Referring to FIG. 10, since the first color portion 60b emits light having a plurality of peak wavelengths, light of the plurality of peak wavelengths may complement each other even when the current value changes. When the color portion emits light of the single peak wavelength, a full width at half maximum is relatively small, and thus, a range of wavelengths that can be covered is narrow. On the contrary, by forming the color portions to emit light of the plurality of peak wavelengths, and by adjusting the current, a CIE (x, y) area A capable of emitting white light may be increased as shown in FIG. 11. In addition, when a current density increases from $32mA/cm^2$ to $120mA/cm^2$, it may change within a range of CIE(x, y) 0.21<x<0.26, or within a range of CIE(x, y) 0.19<y<0.36. Preferably, when the current density increases from $50mA/cm^2$ to $100mA/cm^2$, it may change within a range of CIE(x, y) 0.21<x<0.26, or within a range of CIE(x, y) 0.19<y<0.36.

In this embodiment, it has been described that the first color portion 60b includes the first and second sub-color portions 60b1 and 60b2 and emits light of two peak wavelengths, but the inventive concepts are not limited thereto, and may include a larger number of sub-color portions emitting light of different peak wavelengths.

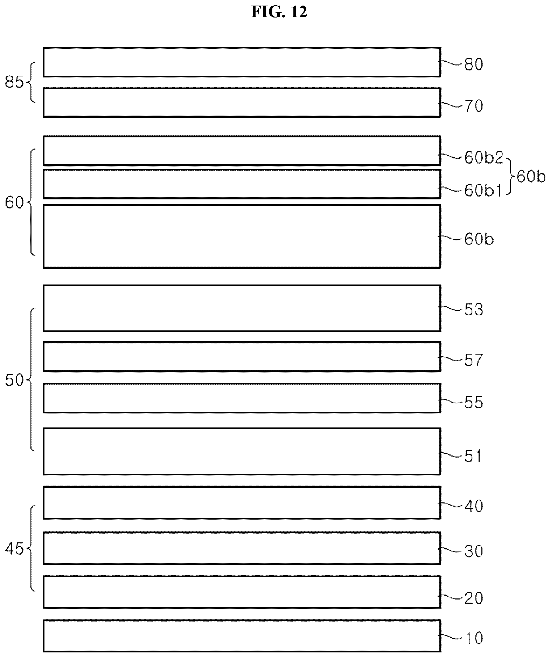

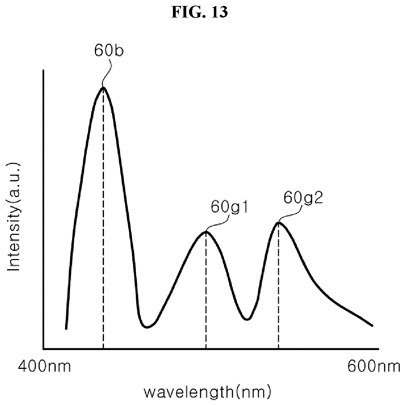

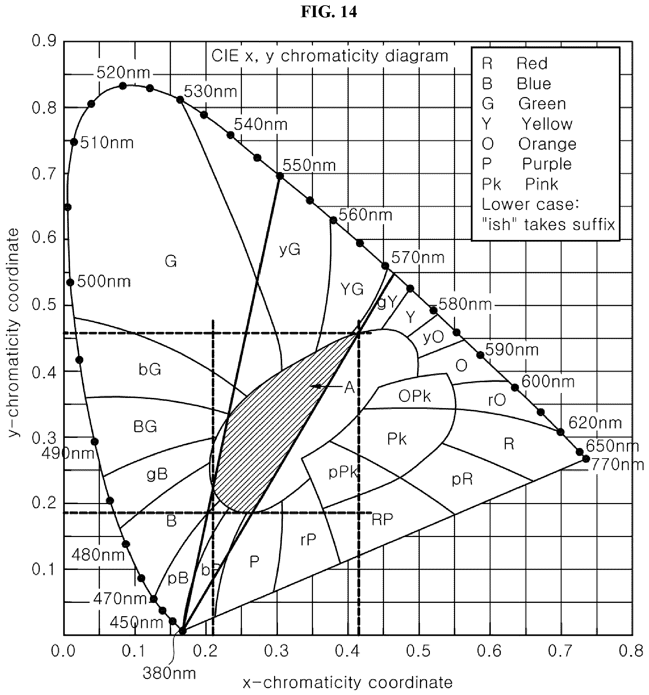

FIG. 12 is a schematic cross-sectional view illustrating a di-chromic device according to a fourth embodiment of the present disclosure, FIG. 13 is a schematic graph illustrating an electroluminescence spectrum of the di-chromic device according to the fourth embodiment of the present disclosure, and FIG. 14 is a CIE chromaticity diagram illustrating color coordinates of light emitted from the di-chromic device according to the fourth embodiment of the present disclosure.

Referring to FIG. 12, the di-chromic device according to this embodiment is substantially similar to the di-chromic device described with reference to FIG. 6, but the first color portion 60b emitting blue light emits light having a single peak wavelength while the color portion 60g emitting green or yellow light includes the first sub-color portion 60g1 and the second sub-color portion 60g2. That is, in this embodiment, the first color portion 60b does not include the sub-color portions 60b1 and 60b2 emitting light having different peak wavelengths.

Since the first sub-color portion 60g1 and the second sub-color portion 60g2 have been described with reference to FIG. 6, detailed descriptions thereof are omitted to avoid redundancy. Meanwhile, the first color portion 60b may emit light having a peak wavelength of 410nm to 495nm. A composition ratio (y) of In in well layers of the first color portion 60b may be 0.1 to 0.18.

When a low current is supplied to the di-chromic device, it is possible to implement white light by a combination of the first color portion 60b emitting light having a peak wavelength of 410nm to 495nm and the first sub-color portion 60g1 emitting light having a peak wavelength of 505nm to 550nm. When a high current is applied to the di-chromic device, a blue shift phenomenon in which a peak wavelength of light emitted from each color portion is shortened may occur due to band bending inside a semiconductor layer. In this case, a combination of the first sub-color portion 60g1 and the first color portion 60b under a low current may be supplemented with a combination of the second sub-color portion 60g2 and the first color portion 60b under a high current, thereby preventing light emitted from the di-chromic device from deviating from white light CIE color coordinates. Accordingly, even when a current value applied to the di-chromic device changes, a change width of the CIE color coordinate may be reduced, thereby stably implementing white light. That is, since a change amount of the CIE color coordinates according to the current change decreases, a probability that white light emitted from the di-chromic device is positioned in a range of CIE (x, y) 0.2≤x≤0.5, 0.19≤y≤0.45 increases. Moreover, even when the current value changes from the low current to the high current as a range of a white region covered by light of peak wavelengths emitted from the color region 60 increases, a probability that the color coordinates of light generated from the di-chromic device are positioned within a white coordinate range of the CIE color coordinates increases. Alternatively, contrary to this, even when the current value changes from the high current to the low current, a mutual complementary action is possible as described above, and thus, stable white color coordinates may be implemented.

Referring to FIG. 13, since the color portion 60g emits light having a plurality of peak wavelengths, light of the plurality of peak wavelengths may complement each other even when the current value changes. When the color portion 60g emits light of the single peak wavelength, a full width at half maximum is relatively small, and thus, a range of wavelengths that can be covered is narrow. On the contrary, by forming the color portions to emit light of the plurality of peak wavelengths, and by adjusting the current, a CIE (x, y) area A capable of emitting white light may be increased as shown in FIG. 14. In addition, when a current density increases from $32mA/cm^2$ to $120mA/cm^2$, it may change within a range of CIE(x, y) 0.21<x<0.42, or may change within a range of CIE(x, y) 0.19<y<0.46. Preferably, when the current density

increases from 50mA/cm$^2$ to 100mA/cm$^2$, it may change within a range of CIE(x, y) 0.21<x<0.42, or may change within a range of CIE(x, y) 0.19<y<0.46.

In this embodiment, it has been described that the color portion 60g includes the first and second sub-color portions 60g1 and 60g2 and emits light of two peak wavelengths, but the inventive concepts are not limited thereto, and may include a larger number of sub-color portions emitting light of different peak wavelengths.

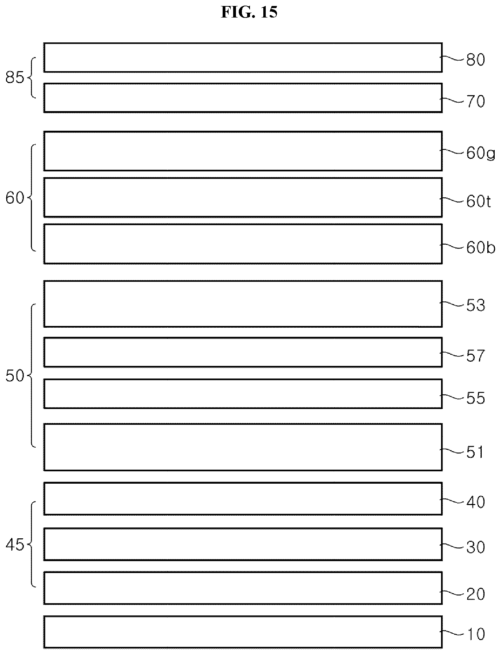

FIG. 15 is a schematic cross-sectional view illustrating a di-chromic device according to a fifth embodiment of the present disclosure.

Referring to FIG. 15, the di-chromic device according to this embodiment is substantially similar to the di-chromic device described with reference to FIG. 3, except that a tunnel barrier layer 60t is disposed between the first color portion 60b and the second color portion 60g.

The tunnel barrier layer 60t is disposed between the color portions 60b and 60g having different band gaps and emitting light of different peak wavelengths to relieve a light interference between the color portions. The tunnel barrier layer 60t may also be disposed between the first color portion 60b and the second color portion 60g in the di-chromic device described with reference to FIGs 6, 9, and 12. By disposing the tunnel barrier layer 60t, white light with high efficiency may be implemented by combining a luminous intensity of blue light and a luminous intensity of green light or yellow light optimized at a low current density of less than 35A/cm$^2$ and a high current density of 35A/cm$^2$ or more, electroluminescence intensities of the color portions 60b and 60g may be adjusted, respectively, and accordingly, a visibility of the di-chromic device may be improved.

Specifically, the tunnel barrier layer 60t may be disposed between the first color portion 60b and the second color portion 60g. The first color portion 60b is disposed close to a first conductivity type semiconductor layer 40, and the second color portion 60g is disposed close to a second conductivity type semiconductor layer 80. The tunnel barrier layer 60t may include an AlGaN layer, or a material layer capable of serving as a color filter, such as DBR. For example, luminous efficiency of the di-chromic device may be increased by preventing shorter wavelength light emitted from the first color portion 60b from affecting the second color portion 60g.

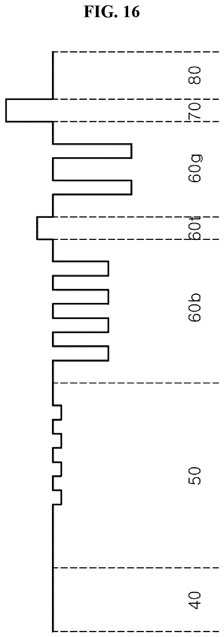

FIG. 16 is a band diagram illustrating the di-chromic device according to the fifth embodiment of the present disclosure.

Referring to FIG. 16, the di-chromic device according to this embodiment includes the first color portion 60b of a multi-quantum well structure and the second color portion 60g of a multi-quantum well structure, and the tunnel barrier layer 60t is disposed between the first color portion 60b and the second color portion 60g. The first color portion 60b may include a plurality of well layers emitting light of a same peak wavelength, and the second color portion 60g may include a plurality of well layers emitting light of a same peak wavelength. However, the inventive concepts are not limited thereto, and the first color portion 60b and/or the second color portion 60g may include well layers emitting light having different peak wavelengths from one another. The tunnel barrier layer 60t may have a band gap larger than those of regions disposed on a front and a back of the tunnel barrier layer 60t, and may have a band gap smaller than that of a resistor 70. A constituent element of the tunnel barrier layer 60t is formed of a same element as an element constituting a barrier layer of the first color portion 60b or the second color portion 60g, but compositions therebetween may be different. Alternatively, the constituent elements of the tunnel barrier layer 60t may be formed of fewer kinds of elements (or atoms) than the elements (or atoms) constituting the barrier layer of the first color portion 60b or the second color portion 60g. Accordingly, generation of a defect due to a difference in sizes of the elements (or atoms) between the first color portion 60b and the second color portion 60g may be prevented, thereby reducing a CIE color coordinate variation due to a defect of an interface.

Herein, it is illustrated that the first color portion 60b includes four well layers and the second color portion 60g includes two well layers, but the inventive concepts are not limited thereto. For example, the first color portion 60b may include 9 well layers, and the second color portion 60g may include 6 well layers.

Meanwhile, a first barrier layer of the first color portion 60b may include a GaN layer, and other barrier layers may include an AlGaN layer. The GaN layer of the first barrier layer of the first color portion 60b may be doped with an n-type impurity, for example, Si, and a doping concentration may be within a range of, for example, 5E18/cm$^3$ to 8E18/cm$^3$. No intentional doping is performed on the other barrier layers. The first barrier layer may also include a hole blocking layer, which may be formed of the AlGaN layer. The hole blocking layer may be disposed at a boundary between a control portion 50 and the first color portion 60b. Meanwhile, the barrier layers disposed between the well layers of the first color portion 60b may be formed of the AlGaN layer. Specifically, each of the barrier layers may include an AlGaN capping layer and a high-temperature AlGaN barrier layer, and the AlGaN capping layer may have a band gap wider than that of the high-temperature AlGaN barrier layer. The AlGaN capping layer may be made thinner than the high-temperature AlGaN barrier layer. For example, the AlGaN capping layer may be formed to have a thickness of about 1nm and the high-temperature AlGaN barrier layer to have a thickness of about 35Å. The AlGaN capping layer is grown at a temperature lower than that for growing the high-temperature AlGaN barrier layer, and for example, it may be grown at a same temperature as a growth temperature of the well layer.

Meanwhile, the well layers in the first color portion 60b may be formed of InGaN or InAlGaN, and may have a composition that emits light in a blue region. The well layers may have a same composition, but the inventive concepts are not limited thereto, and the well layers may have different band gaps from one another.

A first barrier layer of the second color portion 60g may be a GaN layer, and a last barrier layer may be an AlGaN layer. In addition, barrier layers disposed between the well layers may include an AlGaN capping layer, an Al(Ga)N layer, and a GaN layer. In the second color portion 60g, GaN layers of remaining barrier layers except for the last barrier layer may be doped with an n-type impurity, for example, Si. A doping concentration of Si doped in each of the barrier layers of the second color portion 60g may be lower than the doping concentration of Si doped in the first barrier layer of the first color portion 60b, and for example, it may be within a range of $5E17/cm^3$ to $1E18/cm^3$.

Meanwhile, a thickness of each of the well layers of the second color portion 60g may be substantially similar to a thickness of each of the well layers of the first color portion 60b, but the thickness of each of the barrier layers of the second color portion 60g may be greater than the thickness of each of the barrier layers of the first color portion 60b.

The resistor 70 may be disposed to prevent electrons from flowing into the second conductivity type semiconductor layer 80 without recombination. The resistor 70 may be formed of an AlGaN layer, and it may be a grading layer in which a composition of Al gradually increases.

In this embodiment, the second color portion 60g emitting green or yellow light is disposed adjacent to the second conductivity type semiconductor layer, and the first color portion 60b emitting blue light is disposed adjacent to the first conductivity type semiconductor layer. However, the inventive concepts are not limited thereto, and positions of the first color portion 60b and the second color portion 60g may be interchanged.

The tunnel barrier layer 60t is disposed between the first color portion 60b and the second color portion 60g. The tunnel barrier layer 60t may be formed of an AlGaN layer or DBR. A band gap of the tunnel barrier layer 60t may be narrower than those of the barrier layers of the first color portion 60b and the second color portion 60g, without being limited thereto.

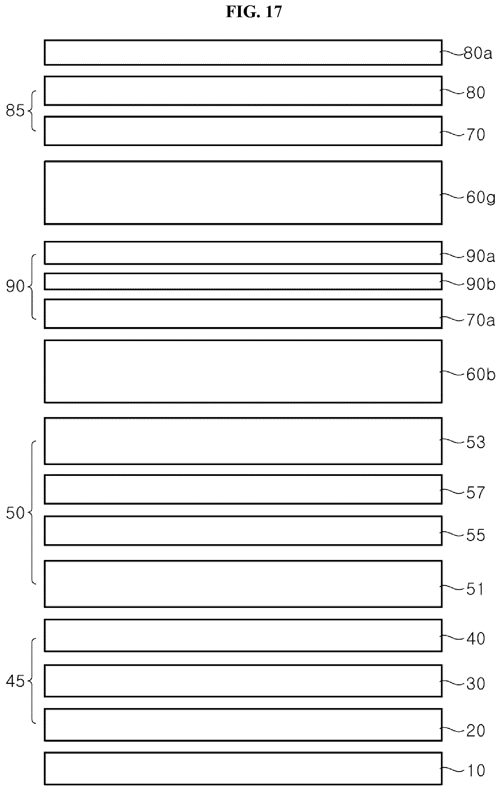

FIG. 17 is a schematic cross-sectional view illustrating a di-chromic device according to a sixth embodiment of the present disclosure.

Referring to FIG. 17, the di-chromic device according to this embodiment is substantially similar to the di-chromic device described with reference to FIG. 3, except that a bridge region 90 is further included between the first color portion 60b and the second color portion 60g. Furthermore, the di-chromic device according to this embodiment may further include a sub-electron blocking layer 70a and an upper high-concentration doping layer 80a. The bridge region 90 and the sub-electron blocking layer 70a may be disposed between the first color portion 60b and the second color portion 60g in the di-chromic device described with reference to FIGs 6, 9, and 12.

The bridge region 90 is disposed between the first color portion 60b and the second color portion 60g. The bridge region 90 includes a first conductivity type high-concentration doping layer 90b and a second conductivity type high-concentration doping layer 90a. The first conductivity type high-concentration doping layer 90a may have a same conductivity type as that of a first conductivity type semiconductor layer 40, and has a doping concentration equal to or greater than that of impurities doped in the first conductivity type semiconductor layer 40. The first conductivity type high-concentration doping layer 90a may have a thickness of, for example, 150Å to 5,000Å, further, 150 Å to 2,000 Å, and may have a doping concentration of $5E19/cm^3$ to $5E20/cm^3$. The second conductivity type high-concentration doping layer 90b may have a same conductivity type as that of a second conductivity type semiconductor layer 80, and has a doping concentration equal to or greater than that of impurities doped in the second conductivity type semiconductor layer 80. The second conductivity type high-concentration doping layer 90b may have a thickness of 150Å to 300Å, and may have a doping concentration of $1E20/cm^3$ to $1E21/cm^3$. The first conductivity type high-concentration doping layer 90a may be thicker than the second conductivity type high-concentration doping layer 90b. The second conductivity type high-concentration doping layer 90a is disposed closer to the first conductivity type semiconductor layer 40 than the first conductivity type high-concentration doping layer 90b.

The sub-electron blocking layer 70a is disposed between the first color portion 60b and the bridge region 90. The sub-electron blocking layer 70a may have a larger Al content and a wider energy band gap than those of layers disposed over and under it. The energy band gap of the sub-electron blocking layer 70a may be smaller than that of a resistor 70 formed on the second color portion 60g. When the energy band gap of the sub-electron blocking layer 70a disposed between the first color portion 60b and the second color portion 60g is excessively large, a flow of current may be blocked, thereby reducing a radiation efficiency. Accordingly, flows of electrons and holes may be controlled by making the energy band gap of the sub-electron blocking layer 70a smaller than that of the resistor 70. **In** addition, by making the Al content in the sub-electron blocking layer 70a smaller than the Al content in the resistor 70, strain formed inside the di-chromic device may be reduced.

The upper high-concentration doping layer 80a may be disposed on the second conductivity type semiconductor layer 80, and may have a same conductivity type as that of the second conductivity type semiconductor layer 80. The upper high-concentration doping layer 80a may be used as a contact layer of electrodes to lower contact resistance.

**In** this embodiment, well layers and barrier layers in the first color portion 60b may be grown at different growth temperatures, and may include 1 to 15 well layers and barrier layers. The first color portion 60b may include a plurality of well layers and a plurality of barrier layers, and may include, for example, each of 9 to 12 well layers and barrier layers. Well layers and barrier layers in the second color portion 60g may be grown at different growth temperatures, and may include 1 to 6 well layers and barrier layers. The second color portion 60g may include a plurality of well layers and a plurality of barrier layers, and may include, for example, each of 3 to 9 well layers and barrier layers.

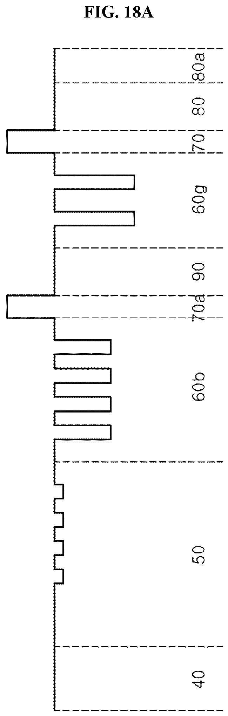

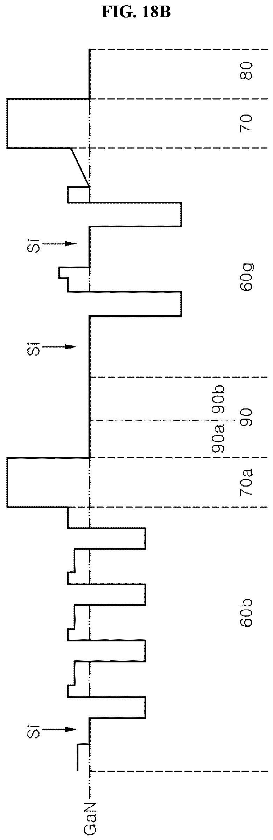

FIG. 18A is a schematic band diagram illustrating the di-chromic device according to the sixth embodiment of the present disclosure, and FIG. 18B is a band diagram showing enlarged portions of the first color portion 60b and the second color portion 60g of FIG. 18A. In FIGs. 18A and 18B, only conduction bands are shown, and in FIG. 18B, a position of the conduction band of each layer is shown with respect to a conduction band of GaN.

Referring to FIGs. 18A and 18B, the di-chromic device according to this embodiment includes the first color portion 60b of a multi-quantum well structure and the second color portion 60g of a multi-quantum well structure, and the sub-electron blocking layer 70a and the bridge region 90 are disposed between the first color portion 60b and the second color portion 60g. The first color portion 60b may include a plurality of well layers emitting light of a same peak wavelength, and the second color portion 60g may include a plurality of well layers emitting light of a same peak wavelength. However, the inventive concepts are not limited thereto, and the first color portion 60b and/or the second color portion 60g may include well layers emitting light having different peak wavelengths from one another.

Herein, it is illustrated that the first color portion 60b includes four well layers and the second color portion 60g includes two well layers, but the inventive concepts are not limited thereto. For example, the first color portion 60b may include 9 well layers, and the second color portion 60g may include 6 well layers.

Meanwhile, a first barrier layer of the first color portion 60b may include a GaN layer, and other barrier layers may include an AlGaN layer. The GaN layer of the first barrier layer of the first color portion 60b may be doped with an n-type impurity, for example, Si, and a doping concentration may be within a range of, for example, $5E18/cm^3$ to $8E18/cm^3$. No intentional doping is performed on the other barrier layers. The first barrier layer may also include a hole blocking layer, which may be formed of the AlGaN layer. The hole blocking layer may be disposed at a boundary between a control portion 50 and the first color portion 60b. Meanwhile, the barrier layers disposed between the well layers of the first color portion 60b may be formed of the AlGaN layer. Specifically, each of the barrier layers may include an AlGaN capping layer and a high-temperature AlGaN barrier layer, and the AlGaN capping layer may have a band gap wider than that of the high-temperature AlGaN barrier layer. The AlGaN capping layer may be made thinner than the high-temperature AlGaN barrier layer. For example, the AlGaN capping layer may be formed to have a thickness of about 1nm and the high-temperature AlGaN barrier layer to have a thickness of about 35Å. The AlGaN capping layer is grown at a temperature lower than that for growing the high-temperature AlGaN barrier layer, and for example, it may be grown at a same temperature as a growth temperature of the well layer.

Meanwhile, the well layers in the first color portion 60b may be formed of InGaN or InAlGaN, and may have a composition that emits light in a blue region. The well layers may have a same composition, but the inventive concepts are not limited thereto, and the well layers may have different band gaps from one another.

A first barrier layer of the second color portion 60g may be a GaN layer, and a last barrier layer may be an AlGaN layer. In addition, barrier layers disposed between the well layers may include an AlGaN capping layer, an Al(Ga)N layer, and a GaN layer. In the second color portion 60g, GaN layers of remaining barrier layers except for the last barrier layer may be doped with an n-type impurity, for example, Si. A doping concentration of Si doped in each of the barrier layers of the second color portion 60g may be lower than the doping concentration of Si doped in the first barrier layer of the first color portion 60b, and for example, it may be within a range of $5E17/cm^3$ to $1E18/cm^3$.

Meanwhile, a thickness of each of the well layers of the second color portion 60g may be substantially similar to a thickness of each of the well layers of the first color portion 60b, but the thickness of each of the barrier layers of the second color portion 60g may be greater than the thickness of each of the barrier layers of the first color portion 60b.

A resistor 70 may be disposed to prevent electrons from flowing into the second conductivity type semiconductor layer 80 without recombination. The resistor 70 may be formed of an AlGaN layer, and it may be a grading layer in which a composition of Al gradually increases.

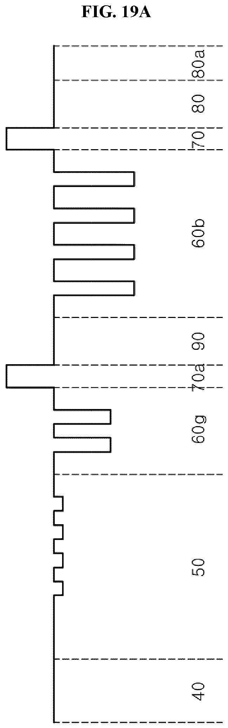

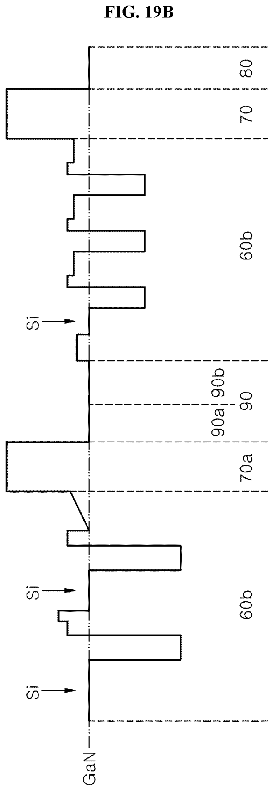

In this embodiment, the second color portion 60g emitting green or yellow light is disposed adjacent to the second conductivity type semiconductor layer, and the first color portion 60b emitting blue light is disposed adjacent to the first conductivity type semiconductor layer. However, the inventive concepts are not limited thereto, and positions of the first color portion 60b and the second color portion 60g may be interchanged. This will be described later with reference to FIGs. 19A and 19B.

The sub-electron blocking layer 70a may have a band gap wider than those of the barrier layers of the first and second color portions 60a and 60b, and may have a band gap that is equal to or narrower than that of the resistor 70. The bridge region 90 may be disposed between the first color portion 60b and the second color portion 60g, and may be disposed on the sub-electron blocking layer 70a. The bridge region 90 may have a same energy band gap as that of GaN.

FIG. 19A is a schematic band diagram illustrating a di-chromic device according to a seventh embodiment of the present disclosure, and FIG. 19B is a band diagram showing enlarged portions of a first color portion 60b and a second color portion 60g of FIG. 19A. In FIGs. 19A and 19B, only conduction bands are shown, and in FIG. 19B, a position of the conduction band of each layer is shown with respect to a conduction band of GaN.

Referring to FIGs. 19A and 19B, the di-chromic device according to this embodiment is substantially similar to the di-chromic device described with reference to FIGs. 18A and 18B, except that positions of the first color portion 60b and the second color portion 60g are changed. That is, in this embodiment, the second color portion 60g is disposed closer to the first conductivity type semiconductor layer 40 than the first color portion 60b. Since other details have been described with reference to FIGs. 18A and 18B, detailed descriptions are omitted to avoid redundancy.

(Experimental Example)

To compare change amounts ΔCIE (Δu'v') of CIE color coordinates according to a change in current densities, the well layers of the first color portion 60b and the second color portion 60g were variously configured as shown in Table 1, with other conditions being the same. The well layers were formed of InGaN, and a composition of each well layer was set to have an energy band gap emitting light of a target wavelength. For example, an energy band gap of 2.85eV is required to emit light of a target wavelength of about 435nm, and an In composition ratio for this was set at about 0.1. An energy band gap of 2.79eV is required to emit light of a target wavelength of about 445nm, and an In composition ratio for this was set at about 0.13. An energy band gap of 2.73eV is required to emit light of a target wavelength of about 455nm, and an In composition ratio for this was set at about 0.16. In addition, to emit light of target wavelengths of about 550nm, about 560nm, and about 570nm, energy band gaps of 2.25eV, 2.21eV, and 2.18eV are required, respectively, and In composition ratios for these were set at about 0.3, about 0.325, and about 0.35, respectively. For samples of Examples 1 through 5, color coordinates (u', v') were measured at current densities of 32 mA/cm$^2$ and 120 mA/cm$^2$, respectively, and change amounts (Δu'v') of color coordinates were obtained.

Table 1

| Example | First color portion | Second color portion | Δu'v' |
|---|---|---|---|
| | Target wavelength (number of well layers) | Target wavelength (number of well layers) | |
| Example 1 | 435nm(9) | 550nm(6) | 0.180 |
| Example 2 | 445nm(5)/455nm(4) | 550nm(6) | 0.103 |
| Example 3 | 435nm(9) | 550nm(3)/560nm(3) | 0.081 |
| Example 4 | 445nm(5)/455nm(4) | 550nm(3)/560nm(3) | 0.076 |
| Example 5 | 445nm(5)/455nm(4) | 550nm(2)/560nm(2)/570nm(2) | 0.063 |

Referring to Table 1, in a case that the first color portion and the second color portion include well layers emitting light of a plurality of different peak wavelengths, it can be seen that the change amount of color coordinates decreases as the current density increases, compared to a case of having well layers emitting light of a same peak wavelength. By configuring the well layers of the second color portion to emit light of a plurality of peak wavelengths compared to the first color portion, the change amount of color coordinates according to the change in current densities may be further reduced.

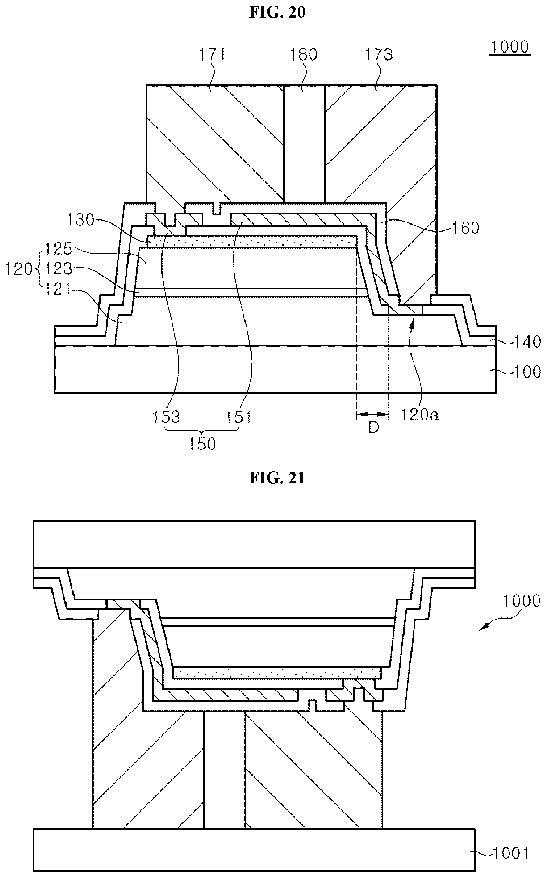

FIG. 20 is a schematic cross-sectional view illustrating a light emitting device 1000 according to an embodiment of the present disclosure.

Referring to FIG. 20, the light emitting device 1000 according to this embodiment is obtained by adding an electrode structure to the di-chromic device described in the previous embodiments. Specifically, the light emitting device 1000 includes a base 100, a di-chromic device 120, an ohmic electrode 130, a first insulation layer 140, a pair of pad electrodes 150; 151 and 153, a second insulation layer 160, bump electrodes 171 and 173, and a filling layer 180.

Since the base 100 is same as the base 10 described above, a detailed description thereof will be omitted to avoid redundancy. In addition, the di-chromic device 120 includes a first conductivity type semiconductor region 121, a color region 123, and a second conductivity type semiconductor region 125 as the color device of the above-described embodiments, and includes a control portion although not shown in the drawing.

A portion of the first conductivity type semiconductor region 125 is exposed by etching the second conductivity type semiconductor region 125 and the color region 123. An exposed surface of the first conductivity type semiconductor region 121 becomes a first conductivity type contact region 120a. Meanwhile, an upper surface of the second conductivity type semiconductor region 125 may serve as a second conductivity type semiconductor contact region. The ohmic electrode 130 may be disposed on the second conductivity type semiconductor region 125 to provide an ohmic contact.

The ohmic electrode 130 may be formed of a metal material (Al, Ti, Ni, Ag, Au, W, Sn, etc.) or a transparent conductive oxide (ITO, ZnO, AZO, IZO, etc.). The first insulation layer 140 may cover the ohmic electrode 130. The first insulation layer 140 covers a portion of the ohmic electrode 130 and may cover a side surface of a mesa and a portion of the first conductivity type contact region 120a by a distance D. The first insulation layer 140 may include $SiO_2$, $SiN_x$, $TiO_2$,

$Al_2O_3$, and the like, and may include a distributed bragg reflector. The first insulation layer 140 may also cover a side surface of the first conductivity type semiconductor region 121 and an upper surface of the base 100.

A portion of the ohmic electrode 130 and a portion of the first conductivity type contact region 120a may be exposed without being covered by the first insulation layer 140, and the pad electrodes 150; 151 and 153 formed on the first insulation layer 140 may be electrically connected to the exposed ohmic electrode 130 and the second conductivity type contact region 120a.

The bump electrodes 171 and 173 are formed over the pad electrodes 150; 151 and 153 and may include metal materials such as Al, Ti, Ni, Ag, Au, W, Sn, and the like. The bump electrodes 171 and 173 may be electrically connected to the pad electrodes 150; 151 and 153 to transfer electricity supplied from a circuit board to the di-chromic device 120.

The second insulation layer 160 may be further formed between the bump electrodes 171 and 173 and the pad electrodes 150; 151 and 153. The second insulation layer 160 may include $SiO_2$, $SiN_x$, $TiO_2$, $Al_2O_3$, and a distributed Bragg reflector. Although the bump electrodes 171 and 173 are shown in FIG. 20 as being disposed thereon, the light emitting device 1000 may be flip-mounted on a circuit board 1001 and electrically connected as shown in FIG. 21, light may be emitted to the outside through the first conductivity type semiconductor region 121 and the base 100.

Meanwhile, the color region may be formed of a nitride semiconductor, and may emit light having peak wavelengths equal to or greater than the number of the pad electrodes 151 and 153.

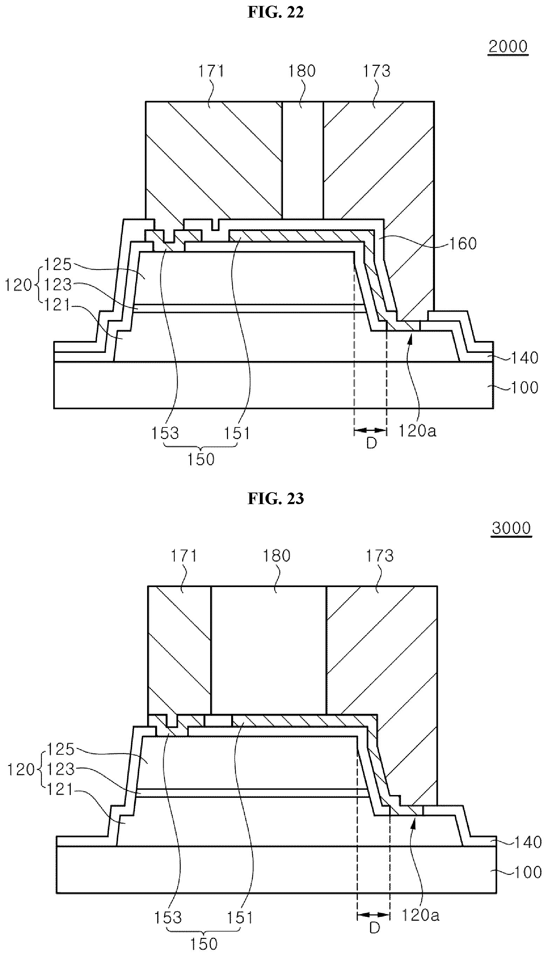

FIG. 22 is a schematic cross-sectional view illustrating a light emitting device 2000 according to another exemplary embodiment of the present disclosure.

Referring to FIG. 22, the light emitting device 2000 according to this embodiment is substantially similar to the light emitting device 1000 described with reference to FIG. 20, except that the ohmic electrode 130 is omitted.

That is, in the light emitting device 2000, the electrode pad 153 formed on the insulation layer 140 without an additional ohmic electrode is in ohmic contact with the second conductivity type semiconductor region 125 to serve as an ohmic electrode. The light emitting device 2000 may also be flip-mounted on the circuit board 1001 as shown in FIG. 13.

FIG. 23 is a schematic cross-sectional view illustrating a light emitting device 3000 according to another exemplary embodiment of the present disclosure.

Referring to FIG. 23, the light emitting device 3000 according to this embodiment is substantially similar to the light emitting device 2000 described with reference to FIG. 22, except that the second insulation layer 160 is omitted. The insulation layer 140 and the pad electrodes 150; 151 and 153 may be disposed between bump electrodes 171 and 173 and the di-chromic device 120, and the bump electrodes 171 and 173 may be formed directly on the pad electrodes 150; 151 and 153. As described with reference to FIG. 13, the light emitting device 3000 may be flip-mounted on the circuit board 1001, and light is emitted to the outside through the first conductivity type semiconductor region 121 and the base 100.

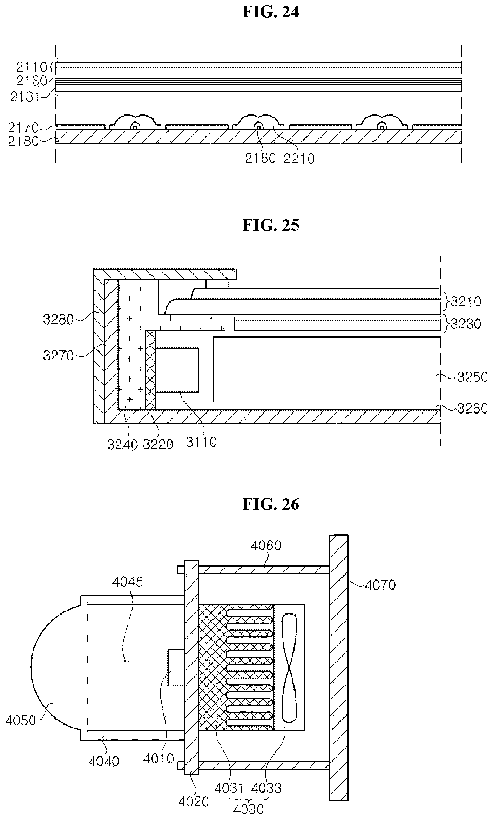

FIG. 24 is a cross-sectional view illustrating a display apparatus to which a di-chromic device according to an embodiment of the present disclosure is applied.

The display apparatus of this embodiment includes a display panel 2110, a backlight unit providing light to the display panel 2110, and a panel guide supporting a lower edge of the display panel 2110.

The display panel 2110 is not particularly limited, and may be, for example, a liquid crystal display panel including a liquid crystal layer. A gate driving PCB for supplying a driving signal to a gate line may be further disposed at an edge of the display panel 2110. Herein, the gate driving PCB may not be configured in an additional PCB, but may be formed on a thin film transistor substrate.

The backlight unit includes a light source module including at least one substrate and a plurality of light emitting devices 2160. Furthermore, the backlight unit may further include a base substrate 2180, a reflection unit 2170, a diffusion plate 2131, and optical sheets 2130.

The base substrate 2180 may open upward and accommodate the substrate, the light emitting device 2160, the reflection sheet 2170, the diffusion plate 2131, and the optical sheets 2130. In addition, the base substrate 2180 may be coupled with the panel guide. The base substrate 2180 may be disposed under the reflection unit 2170, and the light emitting device 2160 may be disposed surrounded by the reflection unit 2170. However, without being limited thereto, the light emitting device 2160 may be disposed on the reflection unit 2170 when a reflective material is coated on a surface of the base substrate 2180. In addition, a plurality of substrates may be formed, and the plurality of substrates may be disposed in a form flush with one another, without limited thereto, and the backlight unit may include a single substrate.

The light emitting device 2160 may include the di-chromic device according to the above-described embodiments of the present disclosure. The light emitting devices 2160 may be regularly arranged in a predetermined pattern on the substrate. The light emitting devices 2160 may be arranged in a square shape, or in another form, may be staggered not to overlap adjacent light emitting devices 2160.

In addition, a light guide 2210 may be disposed on each of the light emitting devices 2160, thereby improving uniformity of light emitted from the plurality of light emitting devices 2160. The light guide 2210 may be one of materials such as Si, a lens, and a resin including a phosphor. The light guide 2210 may have an upper surface parallel to the base substrate 2180, or may have a convex curved surface.

The diffusion plate 2131 and the optical sheets 2130 are disposed on the light emitting device 2160. Light emitted from the light emitting device 2160 may be supplied to the display panel 2110 in a form of a surface light source via the diffusion plate 2131 and the optical sheets 2130.

As such, the light emitting device according to the embodiments of the present disclosure may be applied to a direct-type display apparatus as this embodiment.

FIG. 25 is a cross-sectional view illustrating a display apparatus to which a di-chromic device according to another embodiment of the present disclosure is applied.

The display apparatus having a backlight unit according to this embodiment includes a display panel 3210 on which an image is displayed, and a backlight unit disposed on a rear surface of the display panel 3210 to emit light. Furthermore, the display apparatus includes a frame 240 supporting the display panel 3210 and accommodating the backlight unit, and covers 3240 and 3280 surrounding the display panel 3210.

The display panel 3210 is not particularly limited, and may be, for example, a liquid crystal display panel including a liquid crystal layer. A gate driving PCB for supplying a driving signal to a gate line may be further disposed at an edge of the display panel 3210. Herein, the gate driving PCB may not be configured in an additional PCB, but may be formed on a thin film transistor substrate. The display panel 3210 is secured by the covers 3240 and 3280 disposed under and over the display panel 3210, and the cover 3280 disposed under the display panel 3210 may be coupled to the backlight unit.

The backlight unit providing light to the display panel 3210 includes a lower cover 3270 having a partially opened upper surface, a light source module disposed on an inner side of the lower cover 3270, and a light guide plate 3250 disposed in parallel with the light source module to convert point light into surface light. In addition, the backlight unit of this embodiment may further include optical sheets 3230 disposed on the light guide plate 3250 to diffuse and condense light, and a reflection sheet 3260 disposed under the light guide plate 3250 to reflect light proceeding in a lower direction of the light guide plate 3250 toward the display panel 3210.

The light source module includes a substrate 3220 and a plurality of light emitting devices 3110 spaced apart from one another at regular intervals on one surface of the substrate 3220. The substrate 3220 is not limited as long as it supports the light emitting device 3110 and is electrically connected to the light emitting device 3110, and may be, for example, a printed circuit board. The light emitting device 3110 may include at least one di-chromic device according to the above-described embodiments of the present disclosure. Light emitted from the light source module is incident on the light guide plate 3250 and supplied to the display panel 3210 through the optical sheets 3230. Through the light guide plate 3250 and the optical sheets 3230, point light sources emitted from the light emitting devices 3110 may be transformed into surface light sources.

As such, the di-chromic device according to embodiments of the present disclosure may be applied to an edge type display apparatus as this embodiment.

FIG. 26 is a cross-sectional view illustrating a lighting apparatus to which a di-chromic device according to another embodiment of the present disclosure is applied.

Referring to FIG. 26, the lighting apparatus includes a lamp body 4070, a substrate 4020, a light emitting device 4010, and a cover lens 4050. Furthermore, the lighting apparatus may further include a heat dissipation unit 4030, a support rack 4060, and a connection member 4040.

The substrate 4020 is secured by the support rack 4060 and disposed apart over the lamp body 4070. The substrate 4020 is not limited as long as it can support the light emitting device 4010, and may be, for example, a substrate having a conductive pattern such as a printed circuit board. The light emitting device 4010 may be disposed on the substrate 4020, and supported and secured by the substrate 4020. In addition, the light emitting i-chromic device 4010 may be electrically connected to an external power source through the conductive pattern of the substrate 4020. In addition, the light emitting device 4010 may include at least one di-chromic device according to the above-described embodiments of the present disclosure.

The cover lens 4050 is disposed on a path along which light emitted from the light emitting device 4010 moves. For example, as shown in the drawings, the cover lens 4050 may be disposed apart from the light emitting device 4010 by the connection member 4040, and disposed in a direction in which light emitted from the light emitting device 4010 is to be provided. A viewing angle and/or color of light emitted from the lighting apparatus to the outside may be adjusted by the cover lens 4050. Meanwhile, the connection member 4040 secures the cover lens 4050 to the substrate 4020, and may serve as a light guide by being disposed to surround the light emitting device 4010 and providing a light emitting path 4045. In this case, the connection member 4040 may be formed of a light reflective material or coated with a light reflective material. Meanwhile, the heat dissipation unit 4030 may include a heat dissipation fin 4031 and/or a heat dissipation fan 4033, and may emit heat generated when the light emitting device 4010 is driven to the outside, but is not limited thereto, and it may not include a component related to heat dissipation.

As such, the di-chromic device according to embodiments of the present disclosure may be applied to a lighting apparatus or a headlamp for a vehicle as in this embodiment.

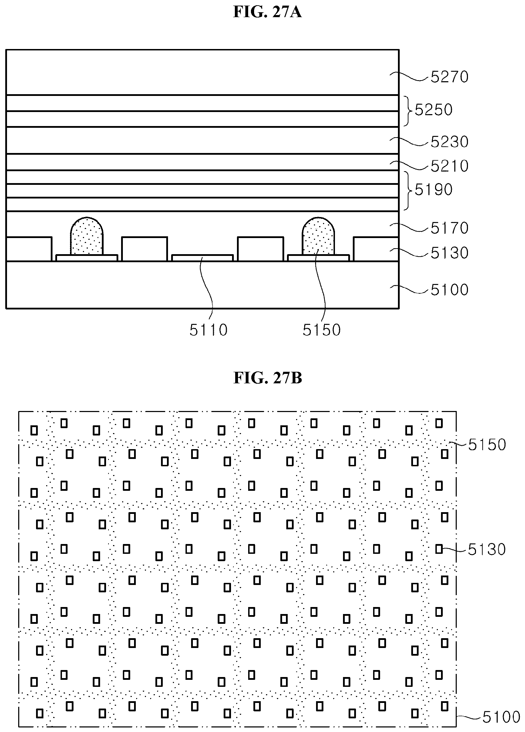

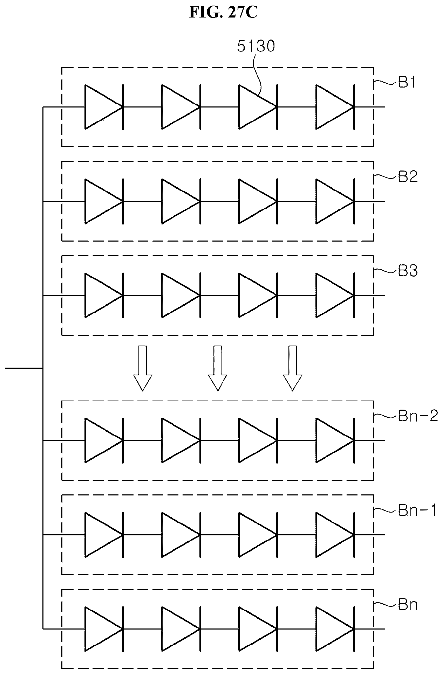

FIGs. 27A, 27B, and 27C are a schematic cross-sectional view, a plan view, and a circuit diagram illustrating a display apparatus to which a di-chromic device according to another embodiment of the present disclosure is applied, respectively. FIG. 27A is a partial cross-sectional view of the display apparatus, FIG. 27B is a plan view of a backlight unit, and FIG. 27C is a circuit diagram of the backlight unit.

Referring to FIGs. 27A, 27B, and 27C, the display apparatus of this embodiment includes a display panel 5270 and a backlight unit providing light to the display panel 5270.

The display panel 5270 is not particularly limited and may be, for example, a liquid crystal display panel including a liquid crystal layer. A gate driving PCB for supplying a driving signal to a gate line may be further disposed at an edge of the display panel 5270. Herein, the gate driving PCB may not be formed on an additional PCB, but may be formed on a thin film transistor substrate.

The backlight unit may include a circuit board 5100, a reflection unit 5110, a light emitting device 5130, a dam portion 5150, a molding member 5170, a diffusion film 5190, a blue light transmittance (BLT) film, a quantum dot (QD) film 5230, and a brightness enhancement film 5250.

The backlight unit includes a circuit board 5100 and a light source module including a plurality of light emitting devices 5130 disposed on the circuit board 5100. One light source module may be used as the backlight unit, or a plurality of light source modules may be arranged on a plane and used as the backlight unit.

The reflection unit 5110 may be disposed on a surface of the circuit board 5100 as shown in FIG. 27A. The reflection unit 5110 may be provided as a reflection sheet or coated on the circuit board 5100. The reflection unit 5110 may surround the light emitting devices 5130 by being formed around a region where the light emitting devices 5130 are mounted. However, the inventive concepts are not limited thereto, and the light emitting devices 5130 may be disposed on the reflection unit 5110.

The circuit board 5100 has circuits for supplying power to the light emitting devices 5130. The light emitting devices 5130 may be connected in series, parallel, or series-parallel through circuits formed on the circuit board 5100. An electrical connection structure of the light emitting devices 5130 will be described later with reference to FIG. 27C.

The light emitting device 5130 includes at least one di-chromic device of the present disclosure described above, and detailed description thereof is omitted.

The dam portion 5150 is formed on the circuit board 5100. The dam portion 5150 divides a region on the circuit board 5100 into a plurality of blocks, as shown in FIG. 23B. A plurality of light emitting devices 5130 may be disposed in each of the blocks. For example, in this embodiment, four light emitting devices 5130 are disposed in each of the blocks. However, the inventive concepts are not limited thereto, and more or fewer light emitting devices 5130 than four may be disposed in each of the blocks.

The dam portion 5150 may include a reflective material that reflects light generated from the light emitting devices 5130 and may be formed of, for example, white silicone.

The molding member 5170 fills blocks partitioned by the dam portion 5150. The molding member 5170 may be formed of transparent silicone. The dam portion 5150 and the molding member 5170 may include silicone of a same series, and may be formed of, for example, phenyl or methyl. Since the dam portion 5150 and the molding member 5170 include the same type of silicone, a bonding force between the molding member 5170 and the dam portion 5150 may be improved.

The diffusion film 5190 is disposed on the molding member 5170. The diffusion film 5190 diffuses light generated from the light emitting devices 5130 to evenly diffuse light. The diffusion film 5190 may adhere to the molding member 5170, without being limited thereto, and may be spaced apart from the molding member 5170. The diffusion film 5190 may be formed of one sheet, or may be formed of a plurality of sheets as shown in FIG. 27A.

The BLT film 5210 and the QD film 5230 may be disposed on the diffusion film 5190. The QD film 5230 includes quantum dots that convert light emitted from the light emitting devices 5130, for example, blue light, into green light and red light.

The BLT film 5210 transmits light emitted from the light emitting devices 5130, for example, blue light, and reflects green light and red light generated from the QD film 5230. Accordingly, it is possible to prevent green light and red light generated from the QD film 5230 from being lost while proceeding toward the circuit board 5100.

Meanwhile, the brightness enhancement film 5250 is disposed on the QD film 5230 to improve a brightness of light proceeding to the display panel 5270. The brightness enhancement film 5250 may include lower and upper brightness enhancement films, and may further include a dual brightness enhancement film (DBEF).

As shown in FIG. 27B, the light emitting devices 5130 are disposed in blocks partitioned by the dam portion 5150. The light emitting devices 5130 in a same block may be spaced apart from one another at an equal interval. In addition, the light emitting devices 5130 in adjacent blocks may also be spaced apart at a similar interval. As shown in FIG. 27B, the light emitting devices in one block may be arranged in a tilted shape with respect to a quadrangular shaped block.

Meanwhile, as shown in FIG. 27C, the light emitting devices 5130 arranged in each block B1 to Bn may be connected in series to one another. In addition, anodes of the light emitting devices in first to nth blocks may be connected to one another, and cathodes thereof may be spaced apart from one another. For example, anodes of the light emitting devices in a first block B1 and anodes of the light emitting devices in a second block B2 are connected to one another, and cathodes of the light emitting devices in the first block B1 and cathodes of the light emitting devices of the second block B2 are electrically spaced apart from one another. Accordingly, the light emitting devices 5130 may be independently driven in units of blocks.

According to this embodiment, since the light emitting devices 5130 are independently driven in block units, and for example, a black region may be implemented by turning off the light emitting devices 5130. Therefore, a contrast may be implemented more clearly, and a power consumption may be reduced compared to a conventional LCD display in which a backlight light source is always turned on. Furthermore, by using the QD film, vivid colors may be implemented.

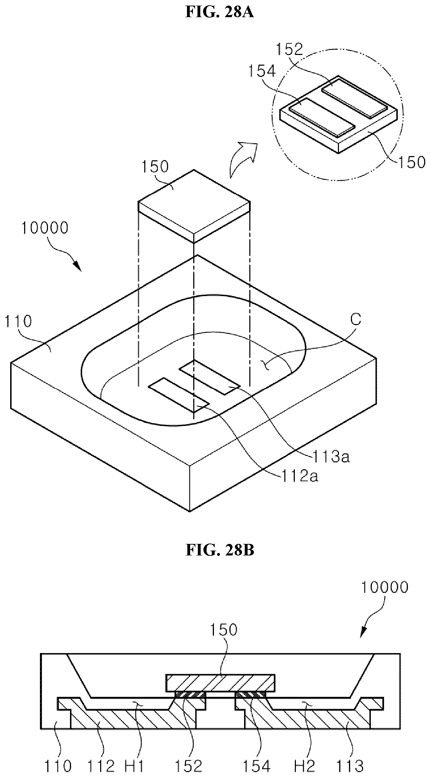

Referring to FIGs. 28A and 28B, a light emitting apparatus 10000 of this embodiment includes a housing 110, a first lead 112, a second lead 113, and a light emitting diode chip 150. The housing 110 is formed in a shape surrounding the first lead 112 and the second lead 113 to support the first lead 112 and the second lead 113. In addition, the housing 110 may fill a space formed between the first lead 112 and the second lead 113. A mounting region may be formed in an upper portion thereof such that portions of upper surfaces of the first lead 112 and the second lead 113 are exposed. The first lead 112 and the second lead 113 are disposed apart from each other, and are provided to supply power to the light emitting diode chip 150. Each of the first lead 112 and the second lead 113 may be partially exposed to the outside in a cavity of the housing 110 to form a first lead exposed surface 112a and a second lead exposed surface 113a. In addition, the first lead 112 and the second lead 113 may be exposed to a lower surface of the housing 110. Additionally, as shown in FIG. 28B, the first lead 112 and the second lead 113 may have first grooves H1 and second grooves H2 formed thereon, respectively. Accordingly, coupling between the housing 110 and the first and second leads 112 and 113 may be enhanced. One or more light emitting diode chips 150 may be provided. The first lead 112 may be electrically connected to a first electrode pad 152 of the light emitting diode chip 150, and the second lead 113 may be electrically connected to a second electrode pad 154 of the light emitting diode chip 150.

As such, the di-chromic device according to embodiments of the present disclosure may be applied to a mini LED display apparatus as this embodiment.

Although some embodiments have been described herein, it should be understood that these embodiments are provided for illustration only and are not to be construed in any way as limiting the present disclosure. It should be understood that features or components of an exemplary embodiment can also be applied to other embodiments without departing from the spirit and scope of the present disclosure.

**Claims**

1. A monolithic di-chromic device, comprising:

   a first conductivity type semiconductor region;
   a control portion disposed on the first conductivity type semiconductor region;
   a color region formed on the control portion; and
   a second conductivity type semiconductor region disposed on the color region, wherein:

      the color region includes a first color portion and a second color portion, the first color portion emits light having a shorter wavelength than that of the second color portion, and
      the first color portion or the second color portion emits light having a plurality of peak wavelengths.

2. The monolithic di-chromic device of claim 1, wherein:

   the first color portion generates blue light,
   the second color portion generates green or yellow light, and
   white light is implemented by a combination of blue light of the first color portion and green or yellow light of the second color portion.

3. The monolithic di-chromic device of claim 1, wherein:

   each of the first color portion and the second color portion includes a plurality of well layers, and
   the number of well layers in the first color portion is greater than that of well layers in the second color portion.

4. The monolithic di-chromic device of claim 1,
   wherein each of the first color portion and the second color portion emits light having a plurality of peak wavelengths.

5. The monolithic di-chromic device of claim 1, further comprising:
   a tunnel barrier layer disposed between the first color portion and the second color portion.

6. The monolithic di-chromic device of claim 5,

wherein the tunnel barrier layer includes an AlGaN layer or DBR.

7. The monolithic di-chromic device of claim 1, further comprising:

a bridge region disposed between the first color portion and the second color,
wherein the bridge region includes a first conductivity-type high-concentration doping layer and a second conductivity-type high-concentration doping layer.

8. The monolithic di-chromic device of claim 7, further comprising:
a sub-electron blocking layer disposed between the first color portion and the bridge region.

9. The monolithic di-chromic device of claim 7,
wherein the first conductivity type high-concentration doping layer is thicker than the second conductivity type high-concentration doping layer.

10. The monolithic di-chromic device of claim 1,
wherein the color region is formed of a nitride semiconductor.

11. The monolithic di-chromic device of claim 1,
wherein a change amount $\triangle$u'v' of CIE color coordinates generated by a change in current densities from 32 mA/cm$^2$ to 120 mA/cm$^2$ is less than 0.11.

12. The monolithic di-chromic device of claim 12,
wherein a change amount $\triangle$u'v' of CIE color coordinates generated by a change in current densities from 32 mA/cm$^2$ to 120 mA/cm$^2$ is less than 0.08.

13. The monolithic di-chromic device of claim 1, wherein:

the first color portion includes well layers emitting light of different peak wavelengths, and
a difference in composition ratios of In in the well layers is within a range of 0.001 to 0.08.

14. The monolithic di-chromic device of claim 13,
wherein an energy band gap difference between the well layers is less than 0.2eV.

15. The monolithic di-chromic device of claim 13,
wherein a composition ratio of In in the well layers of the second color portion is within a range of 0.2 to 0.4.

16. The monolithic di-chromic device of claim 1, wherein:

the second color portion includes well layers emitting light of different peak wavelengths, and
a difference in composition ratios of In in the well layers is within a range of 0.01 to 0.1.

17. The monolithic di-chromic device of claim 16,
wherein a composition ratio of In in the well layers of the first color portion is within a range of 0.10 to 0.18.

18. A light emitting module, comprising:

a circuit board; and
a monolithic di-chromic device disposed on the circuit board,
the monolithic di-chromic device, comprising:

a first conductivity type semiconductor region;
a control portion disposed on the first conductivity type semiconductor region;
a color region formed on the control portion; and
a second conductivity type semiconductor region disposed on the color region, wherein:

the color region includes a first color portion and a second color portion, the first color portion emits light having a shorter wavelength than that of the second color portion, and

the first color portion or the second color portion emits light having a plurality of peak wavelengths.

19. The light emitting module of claim 18,
   wherein a change amount $\triangle$u'v' of CIE color coordinates generated by a change in current densities from 32 mA/cm$^2$ to 120 mA/cm$^2$ is less than 0.11.

20. The light emitting module of claim 18, wherein:

   the first color portion includes well layers emitting light of different peak wavelengths,
   a difference in composition ratios of In in the well layers is within a range of 0.001 to 0.08,
   the second color portion includes well layers emitting light of different peak wavelengths, and
   a difference in composition ratios of In in the well layers is within a range of 0.01 to 0.1.

**FIG. 1**

**FIG. 2**

FIG. 3

**FIG. 4**

**FIG. 5**

EP 4 489 085 A1

**FIG. 6**

25

**FIG. 7**

**FIG. 8**

**FIG. 9**

**FIG. 10**

## FIG. 11

**FIG. 12**

**FIG. 13**

**FIG. 14**

CIE x, y chromaticity diagram

R   Red
B   Blue
G   Green
Y   Yellow
O   Orange
P   Purple
Pk  Pink
Lower case:
"ish" takes suffix

**FIG. 15**

| 85 | 80 |
| | 70 |

| 60 | 60g |
| | 60t |
| | 60b |

| 50 | 53 |
| | 57 |
| | 55 |
| | 51 |

| 45 | 40 |
| | 30 |
| | 20 |

| | 10 |

**FIG. 16**

**FIG. 17**

**FIG. 18A**

FIG. 18B

**FIG. 19A**

FIG. 19B

**FIG. 20**

**FIG. 21**

**FIG. 22**

**FIG. 23**

EP 4 489 085 A1

**FIG. 24**

**FIG. 25**

**FIG. 26**

43

**FIG. 27A**

**FIG. 27B**

**FIG. 27C**

**FIG. 28A**

**FIG. 28B**

| INTERNATIONAL SEARCH REPORT | International application No. |
|---|---|
| | **PCT/KR2023/002904** |

**A. CLASSIFICATION OF SUBJECT MATTER**

**H01L 33/50**(2010.01)i; **H01L 33/06**(2010.01)i; **H01L 33/08**(2010.01)i; **H01L 33/14**(2010.01)i; **H01L 33/32**(2010.01)i

According to International Patent Classification (IPC) or to both national classification and IPC

**B. FIELDS SEARCHED**

Minimum documentation searched (classification system followed by classification symbols)

H01L 33/50(2010.01); H01L 33/00(2010.01); H01L 33/04(2010.01); H01L 33/06(2010.01); H01L 33/08(2010.01); H01L 33/20(2010.01); H01L 33/32(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 모놀리식 다색 소자(monolithic multi-color device), 도전형 반도체 영역 (conductive semiconductor area), 유색 영역(color area), 피크 파장(peak wavelength), 백색광(white light), 우물층(well layer)

**C. DOCUMENTS CONSIDERED TO BE RELEVANT**

| Category* | Citation of document, with indication, where appropriate, of the relevant passages | Relevant to claim No. |
|---|---|---|
| Y | KR 10-0674858 B1 (SAMSUNG ELECTRO-MECHANICS CO., LTD.) 29 January 2007 (2007-01-29)<br>See paragraphs [0019]-[0022], [0026]-[0029] and [0041]-[0043]; and figures 3 and 6. | 1-20 |
| Y | KR 10-2021-0134531 A (SEOUL VIOSYS CO., LTD.) 10 November 2021 (2021-11-10)<br>See paragraphs [0032]-[0035]; and figure 2. | 1-20 |
| Y | US 2009-0001389 A1 (WANG, Dongxue et al.) 01 January 2009 (2009-01-01)<br>See paragraphs [0046] and [0048]; and figure 8. | 5-9 |
| A | US 2016-0043272 A1 (CENTRE NATIONAL DE LA RECHERCHE SCIENTIFIQUE) 11 February 2016 (2016-02-11)<br>See paragraphs [0040]-[0057]; and figures 7-8. | 1-20 |
| A | KR 10-2008-0104368 A (CENTRE NATIONAL DE LA RECHERCHE SCIENTIFIQUE (CNRS)) 02 December 2008 (2008-12-02)<br>See paragraphs [0045]-[0066]; and figures 1-7. | 1-20 |

☐ Further documents are listed in the continuation of Box C.　　　☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **20 June 2023** | **20 June 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

<table>
<tr><td colspan="2"><b>INTERNATIONAL SEARCH REPORT</b><br>Information on patent family members</td><td colspan="2">International application No.<br><br><b>PCT/KR2023/002904</b></td></tr>
</table>

| Patent document cited in search report | Publication date (day/month/year) | Patent family member(s) | | Publication date (day/month/year) |
|---|---|---|---|---|
| KR 10-0674858 B1 | 29 January 2007 | CN | 1893128 A | 10 January 2007 |
| | | DE | 102006002151 A1 | 11 January 2007 |
| | | DE | 102006002151 B4 | 21 July 2011 |
| | | JP | 2007-019455 A | 25 January 2007 |
| | | JP | 4558656 B2 | 06 October 2010 |
| | | TW | 200703713 A | 16 January 2007 |
| | | TW | I291774 B | 21 December 2007 |
| | | US | 2007-0007541 A1 | 11 January 2007 |
| KR 10-2021-0134531 A | 10 November 2021 | CN | 108574031 A | 25 September 2018 |
| | | KR | 10-2018-0103268 A | 19 September 2018 |
| | | KR | 10-2320022 B1 | 02 November 2021 |
| | | US | 10522716 B2 | 31 December 2019 |
| | | US | 2018-0261724 A1 | 13 September 2018 |
| US 2009-0001389 A1 | 01 January 2009 | WO | 2009-002911 A1 | 31 December 2008 |
| US 2016-0043272 A1 | 11 February 2016 | CN | 105122475 A | 02 December 2015 |
| | | CN | 105122475 B | 02 March 2018 |
| | | EP | 2973754 A1 | 20 January 2016 |
| | | FR | 3003402 A1 | 19 September 2014 |
| | | FR | 3003402 B1 | 04 November 2016 |
| | | JP | 2016-513878 A | 16 May 2016 |
| | | WO | 2014-140118 A1 | 18 September 2014 |
| KR 10-2008-0104368 A | 02 December 2008 | EP | 1994571 A1 | 26 November 2008 |
| | | FR | 2898434 A1 | 14 September 2007 |
| | | FR | 2898434 B1 | 23 May 2008 |
| | | JP | 2009-530803 A | 27 August 2009 |
| | | US | 2009-0101934 A1 | 23 April 2009 |
| | | US | 2011-0045623 A1 | 24 February 2011 |
| | | US | 8470618 B2 | 25 June 2013 |
| | | WO | 2007-104884 A1 | 20 September 2007 |

Form PCT/ISA/210 (patent family annex) (July 2022)